(19) Europäisches Patentamt
European Patent Office
Office européen des brevets

(11) EP 2 246 741 A1

(12) **EUROPEAN PATENT APPLICATION**

(43) Date of publication:
**03.11.2010 Bulletin 2010/44**

(51) Int Cl.:
***G03F 7/20*** *(2006.01)* ***G03F 7/11*** *(2006.01)*
***G03F 7/085*** *(2006.01)*

(21) Application number: **10159473.7**

(22) Date of filing: **18.05.2005**

(84) Designated Contracting States:
**AT BE BG CH CY CZ DE DK EE ES FI FR GB GR HU IE IS IT LI LT LU MC NL PL PT RO SE SI SK TR**

(30) Priority: **19.05.2004 JP 2004148760**
**22.07.2004 JP 2004214504**
**26.08.2004 JP 2004246393**

(62) Document number(s) of the earlier application(s) in accordance with Art. 76 EPC:
**05743644.6 / 1 747 500**

(71) Applicant: **Fujifilm Corporation**
**Minato-ku**
**Tokyo (JP)**

(72) Inventors:
- **Hoshi, Satoshi**
  **Shizuoka (JP)**
- **Sunagawa, Hiroshi**
  **Shizuoka (JP)**
- **Inno, Toshifumi**
  **Shizuoka (JP)**
- **Hotta, Yoshinori**
  **Shizuoka (JP)**

(74) Representative: **HOFFMANN EITLE**
**Patent- und Rechtsanwälte**
**Arabellastrasse 4**
**81925 München (DE)**

Remarks:
This application was filed on 09-04-2010 as a divisional application to the application mentioned under INID code 62.

# (54) Image recording method

(57) The present invention relates to a platemaking method of a lithographic printing plate, comprising developing with friction an exposed lithographic printing plate precursor with a developer, wherein the exposed lithographic printing plate precursor is obtained by an image recording method comprising imagewise exposing a lithographic printing plate precursor with an imaging time per pixel of 1 millisecond or less using a laser light with an emission wavelength of from 250 nm to 420 nm. The lithographic printing plate precursor comprises a support and an image recording layer. The image recording layer contains (A) a polymerization initiator and (B) a polymeric compound and is photosensitive in a wavelength of from 250 nm to 420 nm, and the support has an undercoat layer containing a compound that contains a polymerizable group and a support adherent group on the support. The developer used in the platemaking method of the invention is a non-alkaline developer having a pH value of from 2 to 10. After the development with friction, the lithographic printing plate is optionally subjected to washing, drying and desensitizing treatment.



Printed by Jouve, 75001 PARIS (FR)

## Description

Technical Field

The present invention relates to an image recording method and a lithographic printing method in the printing field.

Background Art

Recently, in the lithographic printing field, the computer-to-plate technologies in which platemaking is carried out on a lithographic printing plate precursor through direct laser exposure based on digital data from computer and the like without using a lithographic film, have been developed. A lithographic printing plate of a high sensitivity laser recording type used therefor has been developed.

A conventional lithographic printing plate of the high sensitivity laser recording type, however, has a problem in that it is susceptible to fogging when exposed to an inner drum type plate setter using an Ar (488,514.5 nm) or a FD-YAG (532 mn) laser, which is most generally used in the market. That is, for example, in the case where a negative type plate is used as the sensitive material, if an image such as the entire ink-covered surface on one side of the plate is exposed, there occurs a problem such that fogging, which is thin and development failure, is generated or halftone dots become large on the opposite side (approximately 140 to 220° to the light source, where 180° is taken as the opposite side). Thus, there is a need for improvement.

Furthermore, with the high sensitivity printing plate to be used in conventional laser platemaking process corresponding to the Ar laser or FD-YAG laser, there are occasions in which the plate is removed from corrugated plate package, mounted on a cassette of the plate setter, or manually inserted into the plate setter. In such a case, operation must be carried out under a dark red light, which significantly degrades workability. Compared with this, a common diazo type printing plate can be handled under a yellow light or UV cut white light, and thus has good workability. Therefore, there has been a great demand in the market for the improvement of the adaptability to safelight of a lithographic printing plate for high sensitivity laser recording from the viewpoint of workability.

Accordingly, Patent Document 1 discloses a platemaking method for a lithographic printing plate, **characterized in that** a lithographic printing plate which contains at least sequentially (A) an aluminum support and (B) a laser photosensitive recording layer is exposed with an inner drum type plate setter employing a semiconductor laser light in me region from ultraviolet to the visible light (360 to 450 mn). It is also disclosed that according to this platemaking method, the lithographic printing plate can be handled under a yellow light, and fogging is not generated even during the exposure by the inner drum type plate setter.

Meanwhile, the conventional platemaking process for a lithographic printing plate precursor requires a process of removing by dissolution of unnecessary portions of an exposed image recording layer by means of a developer and the like, Recently, there arises an issue that such additionally carried out wet processing is unnecessitated or simplified.

As one simple and easy platemaking method in accordance with this, there has been proposed a method called the on-press development, wherein a lithographic printing plate is obtained using a lithographic printing plate precursor which has an image recording layer that can be dissolved or dispersed in, for example, printing an ink and/or fountain solution, in such a manner that the lithographic printing plate precursor is mounted on a printing press, and the unexposed area on the image recording layer is removed by supplying a printing an ink and/or a fountain solution onto the exposed plate.

However, when the image recording method employing a light in the region of ultraviolet to the visible light is used for a non-treated printing plate which does not require such development treatment by means of a developer, the image recording layer is not fixed and has photosensitivity with respect to room light even after exposure. Thus, it is necessary to handle such lithographic printing plate precursor under complete shielding from light or in an environment under a safelight, until the on-press development is completed after the plate precursor is taken out from the package. Otherwise, for example, if the image recording layer is handled under a white light after exposure, the portions not needing the image recording layer undergoes fogging, with films remaining behind, thus causing printing contamination. Accordingly, in the prior art, it may be necessary to operate even the printing press, which does not require a safelight, in an environment under a safr-liglit, thus hindering the printing operation such as color adjustment. For this reason, there is a demand for a non-treated printing plate system that can be worked under a white light.

[Patent Document 1] Japanese Patent Laid-open No. 2000-35673

Disclosure of the Invention

The present invention copes with such demand. That is, an object of the invention is to provide an image recording method and a lithographic printing method, wherein broth high sensitivity and safety under white light can be

achieved, and high image quality with good fine line reproducibility can be obtained.

1. An image recording method, comprising imagewise exposing a lithographic printing plate precursor with an imaging tune per pixel of 1 millisecond or less using a laser light with an emission wavelength of from 250 mn to 420 nm, wherein the lithographic printing plate precursor comprises a support and an image recording layer, in which the image recording layer contains (A) a polymerization initiator and (B) a polymeric compound and is photosensitive in a wavelength of from 250 nm to 420 nm, and the support has an anodized film with sealed micropores on the surface.
2. The image recording method according to the item 1, wherein the wavelength of the laser light is selected from 405 nm, 375 nm, 365 nm, 355 nm and 266 mn.
3. The image recording method according to the item 1, wherein the exposure is carried out using an optical system comprising: a DMD or GLV modulation element; and a semiconductor laser with a wavelength of 405 nm or 375 nm.
4. The image recording method according to the item 1, wherein the wavelength of the laser light is selected from 365 nm, 355 nm and 266 nm, and the exposure is carried out in the inner-drum mode.
5. The image recording method according to any one of the items 1 to 4, wherein the image recording layer further contains (C) a binder polymer.
6. A lithographic printing method, comprising: carrying out an on-press development by supplying a printing ink and/or a fountain solution to the exposed biographic printing plate precursor which is obtained by the image recording method according to any one of the items 1 to 5; and printing.
7. A platemaking method of a lithographic printing plate, comprising developing an exposed lithographic printing plate precursor with a developer, wherein the exposed lithographic printing plate precursor is obtained by an image recording method comprising imagewise exposing a lithographic printing plate precursor with an imaging time per pixel of 1 millisecond or less using a laser light with an emission wavelength of from 250 nm to 420 nm, wherein the lithographic printing plate precursor comprises a support and an image recording layer, in which the image recording layer contains (A) a polymerization initiator and (B) a polymeric compound and is photosensitive in a wavelength of from 250 nm to 420 nm.
8. The platemaking method according to the item 7, wherein the support has an anodized film with sealed micropores on the surface.
9. The platemaking method according to the item 7 or 8, wherein the developer is a non-alkaline developer having a pH value of 10 or less.
10. The platemaking method according to any one of the items 7 to 9, wherein the image recording layer further contains (C) a binder polymer.
11. The platemaking method according to claims 10, wherein the binder polymer (C) does not have an acid group.

Although the operating mechanism of the invention is not clear, it is inferred as follows. That is, the light source used in the conventional image recording method is an Ar (488, 514.5 nm) or a FD-YAG (532 nm) laser, a metal halide lamp and the like, and with such a light source, an image is exposed to a light in the region from 300 to 500 nm. Thus, the lithographic printing plate precursor has photosensitivity in that region, which greatly overlaps with room light having a major emission band in the visible region. Further, as the intensity of light irradiation ranges from a low level of illumination to a medium level of illumination, which causes exposure with photosensitivity to the same extent as that of room light, mere occurs an equivalent reaction, and unnecessary image formation under room light is becoming a problem.
In this regard, by shifting the absorption maximum of the photosensitive wavelength to the side of shorter wavelength, the overlapping with the emission spectrum of a white fluorescent light used as room light becomes small. Further, even when the image forming sensitivity of the recording material is sufficiently high, it becomes possible not to have image formation by irradiation of a white fluorescent light (Figs. 1 and 2). In other words, by making the wavelength region of from 250 mn to 420 nm, overlapping with room light can be inhibited to a minimum, and formation of unnecessary images due to irradiation of room light is unhibited.
Further, in the case where a plate material of the radical polymerization type is subjected to exposure and recording, light power needed for film formation greatly varies depending upon the flow rate of oxygen that is introduced into the film. This can be expressed in a phenomenological manner as follows.
Generally, the amount of a radical N generated is directly proportional to the irradiated exposure energy J.
$J = cl \cdot N$ (wherein c1 is a proportionality constant)
The radical generated by irradiated light is scavenged by oxygen introduced into the film. The amount of scavenging No is proportional to the amount of inlet oxygen per unit hour, q, and the elapsed time t from the initiation of exposure.
$No = c2 \cdot q \cdot t$ (wherein c2 is a proportionality constant)
Thereafter, the exposure energy Jo, which is not involved in polymerization even if a radical is generated, can be expressed by the following equation.

$$J_0 = c1 \cdot c2 \cdot q \cdot t$$

Accordingly, the exposure energy J necessary for image formation requires higher irradiation energy than Jo.

Meanwhile, if the amount of the radical generated during short-term exposure is greater than the amount of inlet oxygen, polymerization is likely to be completed in a short time. Thus, the irradiation energy Jth is determined regardless of the amount of inlet oxygen.

This relationship can be plotted as shown in Fig. 3, taking the time taken for irradiation 1 (sec) for the lateral axis, and the irradiation energy J for me vertical axis. Therefore, in case of surface exposure is me same order as in prior art, high irradiation energy is required. In this regard, if irradiation can be caned out in the time region of Jth, an image can be formed with low irradiation energy,

According to the invention, it was found that in the case of combining exposure conditions or materials in which the irradiation time is in a range of 1 msec or less, the amount of a radical generated is sufficiently high, and the polymerization rate increases (e.g., exposure with high level of illumination by a high output UV laser) to a plate material of the radical polymerization type, there is a region that the irradiation energy becomes Jth.

Therefore, as the irradiation time for a pixel is set to 1 msec or less in forming an image on the plate, the irradiation energy used to form a desired image can be reduced. Furthermore, if energy at a high level of illumination does not exist, there is no fogging occurring in a bright room (under a white light) where the illumination is at low level for over several minutes. It is thus possible to obtain good safety under white light.

Moreover, it can be inferred that by using a support having an anodized film with sealed micropores on the surface, the components of the image recording layer can be prevented from entering the micropores, and the on-press developability can be improved, thus leading to further improvement of safety under white light.

Brief Description of the Drawings

Fig. 1 is a chart showing the recording sensitivity of the recording material which causes fogging after two hours of irradiation of a white fluorescent light.
Fig. 2 is a chart showing the emission distribution of a white fluorescent light.
Fig. 3 is a chart showing the irradiation energy necessary for image formation with respect to the irradiation time.
Fig. 4 is a schematic diagram showing the light beam scanning apparatus of the inner drum scanning type used in the invention.
Fig. 5 (a) and (b) are the planar view and the side view, respectively, of an embodiment exhibiting the constitution of an outer drum mode image recording apparatus used in the invention.
Fig. 6 is a sectional view showing the constitution of an exposing head using a DMD space light modulation element, observed in a side scanning direction along the light axis.

Reference Numerals

1 UV LASER
2 ELECTRIC OPTICAL MODULATION ELEMENT
3 HALF MIRROR
4 MIRROR
5 LIGHT DETECTOR
D DRUM
Lo BEAM
L1,L2,L3 LENS
10 IMAGE RECORDING APPARATUS
12 EXPOSING HEAD
14 DRUM
16 BROADBAND ARRAY LASER DIODE
18 CYLINDRICAL LENS
20 COLLIMATE LENS
22, 26 λ/2 PLATE

24 FERROELECTRIC LIQUID CRYSTAL SHUTTER ARRAY
28 OPTICAL ANALYZE
30,32 LENS
40 CONTROLLER
50 DMD (SPACE LIGHT MODULATION ELEMENT)
56 EXPOSED SURFACE
66 FIBER ARRAY OPTICAL SYSTEM
67 LENS SYSTEM
72 LENS SYSTEM
74 LENS SYSTEM
76 MICROLENSARRAY
78 APERTURE
80 LENS SYSTEM
82 LENS SYSTEM

Best mode for Carrying out the invention

Hereinafter, the method for exposure relating to the image recording method of the present invention, the lithographic printing method and the lithographic printing plate precursor used therefor will be sequentially described in detail.

[Method for Exposure]

The scanning exposure method of the lithographic printing plate precursor according to the invention can employ known methods without any limitation. Wavelengths of a light source used in the invention are from 250 nm to 420 nm. In particular, the light source may include gas lasers, such as an Arion laser (364 nm,351 nm, 10 mW to 1 W), a Kr ion laser (356 nm, 351 nm, 10 mW to 1W) and an He-Cd laser (325 nm, 1 mW to 100 mW); solid lasers, such as four-fold wavelength (266 nm, 20 to 100 mW) of a 1064 nm oscillation mode-lock solid laser such as YAG, $YVO_4$, etc., twofold wavelength (400 to 420 nm, 5 to 30 mW) of a single frequency oscillation semiconductor laser (DBR type semiconductor laser: a wavelength of 800 to 840 nm), a combination (380 nm to 400nm, 5mW to 100mW) of a waveguide type wavelength conversion element and an AlGaAs or InGaAs semiconductor, a combination (300 mn to 350 nm, 5 mW to 100 mW) of a waveguide type wavelength conversion element and an AlGaInP or AlGaAs semiconductor and AlGaInN (350 nm to 470 nm, 5 mW to 200 mW); and pulse lasers, such as a $N_2$ laser (337 nm, a pulse of 0.1 to 10 mJ), XeF (351 nm, a pulse of 10 to 250 mJ), three-fold wavelength (355 nm, 1 to 4 W) of a 1064 nm oscillation mode-lock solid laser such as YAG, $YVO_4$, etc., and the like.

Particularly, among them, the most suitable lasers may be the AlGaInN semiconductor laser (a commercial InGaN-based semiconductor laser having a wavelength of 375 run or 405 nm, 5 to 100 mW) from the viewpoint of high illumination and short exposure time that allows a high polymerization rate and in view of the cost, the 355 nm laser having a high output from the viewpoint of the productivity, and the 266 nm laser, which has the smallest emission spectrum overlapping of a white fluorescent light and allows for a high sensitivity from the viewpoint of wavelength suitability.

Further, in a lithographic printing plate exposure apparatus of a scan exposure mode, exposure mechanisms may include inner drum (inner surface drum) mode, outer drum (outer surface drum) mode and flat bed mode. From the viewpoint of the quality and cost, the inner drum mode is the most suitable, and from the viewpoint of the productivity, the outer surface drum mode is the most suitable.

Fig. 4 is a conceptual view showing a cylindrical inner surface scan type optical beam scanning apparatus according to an embodiment of the invention. In tins figure, the reference numeral 1 indicates a UV laser as an optical beam output unit.

The intensity of an UV laser beam Lo is modulated according to an image signal by means of an electric optical modulation element 2. Further, the diameter of the beam is expanded or changed by means of the lens L1 and L2 constituting a beam expander. The beam Lo is guided into a drum Dalong the central axis of the drum (cylindrical) D by means of a half mirror 3 and a mirror 4. A condensing lens L3 and a spinner SP constituting a scanning optical system are installed on the central axis of the drum D.

The spinner SP has a reflecting plane of approximately 45° with respect to the central axis (the rotating axis), and is rotated at high speed by means of a motor. A rotary encoder EN is installed in the motor, and detects a rotation angle ($\theta = \omega t$) of the spinner SP. That is, a pulse signal p, which is output from every predetermined rotation angle, and a reference position signal po indicating 1-rotation reference position are being output. The beam guided into the spinner SP is condensed on an inner surface of the drum D or a recording sheet S through the beam expander EX and the

condensing lens L3 on the rotating axis.

Further, the optical power of the modulated laser beam can be collimated by measuring the laser light, which is bifurcated with the half mirror 3, using a light detector 5.

In the image recording apparatus, while the condensed optical beam is scanned at high speed by means of the spinner, the condensing lens L3 and the spinner SP are moved along the central axis of the drum in a sub-scanning direction at constant speed by means of a moving unit (not shown). A recording medium mounted on the inner surface of the drum D is thus exposed to exposure light projected from the UV laser 1 in two dimensions, whereby an image according to image data is recorded.

Fig. 5 is a conceptual view of the outer drum mode according to an embodiment of the image recording apparatus of the invention. Figs. 5(a) and 5(b) are a plan view and a lateral view of the image recording apparatus 10, respectively, according to the embodiment. In the image recording apparatus 10, a light projected from an illumination light source is modulated according to image data by means of a space light modulation element array, and an image according to the image data is recorded on the recording medium by means of the modulated exposure light. The image recording apparatus 10 includes an exposing head 12 and a drum 14.

The exposing head 12 serves to generate the modulated exposure, light according to image data, and includes a Broadband Area Array Laser Diode (hereinafter, referred to as "BALD") 16 being the illumination light source, a cylindrical lens 18, a collimate lens 20, a λ/2 plate 22, a ferroelectric liquid crystal shutter array 24 being the space light modulation element array, a λ/2 plate 26, an optical analyzer 28, and two lens 30 and 32 being a variable power image formation optical system.

Further, for the illumination light source, a LD array in which respective semiconductor laser chips are arranged in a row, as shown in JP-A No. 2003-158332, is good. Laser light emitted from the laser array 16 is condensed in the up and down direction of Fig. 5(b) by means of the cylindrical lens 18, followed by becoming a parallel light to the up and down direction of Fig. 5(a) by means of the collimated lens 20, and is condensed in the up and down direction of Fig. 5(b), so as to be projected on the λ/2 plate 22.

Thereafter, the laser light has its polarization state rotated by 45( in a direction perpendicular to its progress direction by means of the λ/2 late 22, and is then modulated according to the image data by means of the ferroelectric liquid crystal shutter array 24. In this case, the laser light that passes through the ferroelectric liquid crystal shutter array 24 has its polarization state rotated by 90° by means of the ferroelectric liquid crystal shutter array 24, and has its polarization state rotated by 45° by means of the λ/2 plate 26 so as to be projected on the optical analyzer 28.

The optical analyzer 28 transmits only the laser light whose polarization state is rotated at a predetermined angle, and the other laser lights are shielded. The laser light that passes through the optical analyzer 28 is formed on the recording medium mounted on the drum 14 at a predetermined magnification by means of the two lenses 30 and 32 being the variable power image formation optical system.

The exposing head 12 moves at predetermined constant speed in a sub-scanning direction (the axial direction of the drum 14), while emitting the modulated exposure light according to the image data when an image is recorded on the recording medium.

The drum 14 is a support of the recording medium. When an image is recorded on the recording medium, the recording medium is mounted on the outer surface of the drum 14, and the drum 14 is rotated at predetermined constant speed in a predetermined direction (an opposite direction to a main-scanning direction).

In an image recording apparatus 10, while the drum 14 is moved in an opposite direction to the main-scanning direction at predetermined constant speed by means of a rotary unit (not shown) of the drum 14, the exposing head 12 is moved in a sub-scanning direction at predetermined constant speed by means of a moving unit (not shown) of the exposing head 12, whereby the recording medium mounted on the outer surface of the drum 14 is scanned and exposed to the exposure light emitted from the exposing head 12 in two dimensions, and thus has an image corresponding to image data recorded thereon.

Further, a SLM is not limited to the ferroelectric liquid crystal shutter array 24, but may use all conventional transmission type and reflection type SLMs such as grating light valve (GLV) and digital micromirror device (DMD), and the like. Moreover, the support of the recording medium is not limited to the drum 14, but using a flat panel is also good.

Further, in the embodiment shown in Fig. 5, the exposing head 12 and the drum 14 is moved relatively using the ferroelectric liquid crystal shutter array 24, which carries out linear modulation, and the recording material is scanned and exposed in two dimensions as the space light modulation element array. However, the invention is not limited thereto, but for example, it is also possible in that the exposure light is expanded or contracted at a predetermined magnification using a device capable of subjecting surface modulation, and the recording material is widely exposed simultaneously without being scanned as the space light modulation element array.

The outer drum mode is one in which exposure is implemented through multi-channels by means of an optical system consisting of a combination of a space modulation element, for example, a DMD modulation element or a GLV modulation element, and a 375 nm or 405 nm semiconductor laser, and is preferable advantageous of high productivity and low cost.

Furthermore, the inner drum type using a laser light having the wavelengths selected from any one of 365 nm, 355 nm and 266 nm is preferable advantageous of the high-speed exposure and low cost.

Moreover, the optical system employing the DMD modulation element is disclosed in JP-A No. 2004-012899, and the optical system employing the GLV modulation element is disclosed in JP-A Nos. 2000-168136, 2001-162866, and the like.

The imaging time per pixel is shorter the better since it can prohibit competition reaction with oxygen by minimum, preferably 1 msec or less, more preferably 500 (s or less, the most preferably 100 (s or less. If the imaging time per pixel is 1 msec or more, polymerization degradation by oxygen increases, which results in degradation of image formation.

[Lithographic printing method]

In the lithographic printing method of the invention, as described above, printing is caried out by subjecting the lithographic printing plate precursor of the invention to the development treatment after imagewise exposure, or by supplying an oily ink and an aqueous component without subjecting the plate precursor to any development treatment.

<Development treatment>

For the developer that is used when the development treatment is carried out using a developer, there is no particular limitation. But, in case the binder polymer to be described below which is s contained in the image recording layer contains an acid group such as a carboxyl group, a sulfone group, a phosphoric acid group and the like, those aqueous alkali solutions known in prior art can be used very suitably. For example, mention may be made of an inorganic alkaline agent such as sodium silicate, potassium silicate, trisodium phosphate, tripotassium phosphate, triammonium phosphate, disodium hydrogen phosphate, dipotassium hydrogen phosphate, diammonium hydrogen phosphate, sodium carbonate, potassium carbonate, ammonium carbonate, sodium hydrogen carbonate, potassium hydrogen carbonate, ammonium hydrogen carbonate, sodium borate, potassium borate, ammonium borate, sodium hydroxide, ammonium hydroxide, potassium hydroxide and lithium hydroxide, and the like. Further, an organic alkaline agent such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and the like is also used.

Such alkaline agents are used alone or in a combination of two or more species. Among these aqueous alkali solutions, the developer which exhibits the effect of the invention even better is an aqueous solution containing an alkali metal silicate with a pH value of 12 or more. The aqueous solution of alkali metal silicate is such that its developability can be controlled by the ratio of silicon oxide $SiO_2$ in the silicate component to the alkali metal oxide $M_2O$ (generally represented by the molar ratio of $[SiO_2]/[M_2O]$) and their concentrations. For example, use can be made very suitably of the aqueous solution of sodium silicate as disclosed in the publication of JP-A No. 54-62004, in which solution the molar ratio of $SiO_2/Na_2O$ is from 1.0 to 1.5 (i.e., $[SiO_2]/[Na_2O]$ is from 1.0 to 1.5), and the content of $SiO_2$ is from 1 to 4% by weight of an aqueous solution of sodium silicate; or that of an alkali metal silicate as described in the publication of JP-B No. 57-7427, in which solution the ratio $[SiO_2]/[M]$ is from 0.5 to 0.75 (i.e., $[SiO_2]/[M_2O]$ is from 1.0 to 1.5), and the concentration of $SiO_2$ is from 1 to 4%by weight, and which the solution is such that the developer contains at least 20% by weight of potassium relative to the gram atom of the total alkali metal present in the solution. The pH value of the developer is preferably in a range of from 9 to 13.5, and more preferably in a range of from 10 to 13. The temperature of the developer is preferably from 15 to 40°C, and more preferably from 20 to 35°C. The developing time is preferably from 5 to 60 seconds, and more preferably from 7 to 40 seconds.

Further, it has been known that in the case of developing the photosensitive lithographic printing plate using an automatic developing machine, a large number of photosensitive printing plates can be treated, without changing the developer in the developing tank for a long time, when an aqueous solution (supplementary solution) with higher alkalinity than the developer is added to the developer. This method of supplement is also preferably applicable to the invention. For example, use is made very suitably of a method as described in the publication of JP-A No. 54-62004, in which the molar ratio of $SiO_2/Na_2O$ of the developer is from 1.0 to 1.5 (i.e., $[SiO_2)/[Na_2O]$ is from 1.0 to 1.5], a $SiO_2$ content of 1 to 4% by weight of an aqueous solution of sodium silicate is used, and an aqueous solution of sodium silicate (supplementary solution) having a molar ratio of $SiO_2/Na_2O$ of from 0.5 to 1.5 (i.e., $[SiO_2]/[Na_2O]$ is from 0.5 to 1.5) is added to the developer continuously or discretely depending on the amount of throughput of lithographic printing plate; and further a method of developing as described in the publication of JP-B No. 57-7427, in which the molar ratio of $[SiO_2]/[M]$ is from 0.5 to 0.75 (i.e., $[SiO_2]/[M_2O]$ is from 1.0 to 1.5), a developer of alkali metal silicate having a concentration of $SiO_2$ of from 1 to 4% by weight, the molar ratio of the alkali metal silicate which is used as the supplementary solution, $[SiO_2]/[M]$ is from 0.25 to 0.75 (i.e., $[SiO_2]/[M_2O]$ is from 0.5 to 1.5), and both the developer and the supplementary solution contain at least 20% by weight of potassium based on the gram atom of the total alkali metal present in the respective solutions.

Thus developed photosensitive lithographic printing plate is post-treated with washing water, a rinsing solution containing surfactants and the like and a desensitizing solution containing gum arabic, starch derivatives and the like, as described in the publications of JP-A Nos. 54-8002, 55-115045, 59-58431 and the like. In the post-treatment for the photosensitive lithographic printing plate of the invention, these treatments can be used in various combinations. The lithographic printing plate which can be obtained by such treatments is set up on an offset printing machine and used in multiple printing. Upon printing, the plate cleaner used for the removal of contamination on the plate may be those conventionally known plate cleaners for the PS plates, and they may be exemplified by CL-1, CL-2, CP, CN-4, CN, CG-1, PC-1, SR, IC (manufactured by Fuji Photo Film Co., Ltd.) and the like.

Further, according to the invention, non-alkaline aqueous solutions having a pH value of 10 or less may be also used as the developer, and for example, water alone or an aqueous solution containing water as the predominant component (containing 60% by weight or more of water) is preferred, an aqueous solution having the same composition as conventionally known fountain solutions or an aqueous solution containing surfactants (anionic, nonionic, cationic and the like) being particularly preferred. The pH value of the developer is preferably 2 to 10, more preferably 3 to 9, and even more preferably 4 to 8.

As the anionic surfactant used in the developer of the invention, mention may be made of fatty acid salts, abietic acid salts, hydroxyalkane sulfonates, alkane sulfonates, dialkyl sulfosuccinates, straight-chained alkylbenzene sulfonates, branched alkylbenzene sulfonates, alkylnaphthalene sulfonates, alkylphenoxy polyoxyethylenepropyl sulfonates, polyoxyethylene alkylsulfophenyl ether salts, sodium N-methyl-N-oleyltaurate, disodium salts of N-alkyl sulfosuccinic monoamide, petroleum sulfonates, sulfated castor oil, sulfated beef tallow, sulfate ester salts of fatty acid alkyl esters, alkyl sulfate ester salts, polyoxyethylene alkyl ether sulfate ester salts, fatty acid monoglyceride sulfate ester salts, polyoxyethylene alkylphenyl ether sulfate ester salts, polyoxyethylene strylphenyl ether sulfate ester salts, alkyl phosphate ester salts, polyoxyethylene alkyl ether phosphate ester salts, polyoxyethylene alkylphenyl ether phosphate ester salts, partial saponification products of styrene-maleic anhydride copolymers, partial saponification products of olefin-maleic anhydride copolymers, naphthalene sulfonate-formalin condensates and the like. Among these, dialkyl sulfosuccinates, alkyl sulfate ester salts and alkyl naphthalene sulfonates are particularly preferably used.

The cationic surfactants used in the developer of the invention are not particularly limited, and those known in prior art may be used. For example, alkylamine salts, quaternary ammonium salts, polyoxyethylene alkylamine salts and polyethylene polyamine derivatives may be listed.

As the nonionic surfactant used in the developer of the invention, mention may be made of higher alcohol ethylene oxide adducts of the polyethylene glycol type, alkylphenol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide adducts of fats, polypropylene glycol ethylene oxide adducts, dimethylsiloxane-ethylene oxide block copolymers, dimethylsiloxane-(propylene oxide-ethylene oxide) block copolymers and the like; or fatty acid esters of glycerol of the polyhydric alcohol type, fatty acid esters of pentaerythritol, fatty acid esters of sorbitol and sorbitan, fatty acid esters of sucrose, alkyl ethers of polyhydric alcohols, fatty acid amides of alkanolamines, and the like.

These nonionic surfactants may be used alone or in a combination of two or more species. For the invention, preference is given to the ethylene oxide adducts of sorbitol and/or sorbitan fatty acid esters, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohols.

From the viewpoint of stable solubility or suspendability with respect to water, the nonionic surfactant used in the developer of the invention has a HLB (Hydrophile-Lipophile Balance) value of preferably 6 or more, and more preferably 8 or more.

Also, the proportion of the nonionic surfactant contained in the developer is preferably from 0.01 to 10% by weight, and more preferably from 0.01 to 5% by weight.

Further, the acetylene glycol-based and acetylene alcohol-based oxyethylene adducts, fluorine-based or silicone-based surfactants and the like can be also used.

For the surfactant used in the developer of the invention, nonionic surfactants are particularly suitable from the viewpoint of defoamability.

Further, the developer used in the invention may contain an organic solvent. The organic solvent that can be contained herein may be exemplified by aliphatic hydrocarbons (hexane, heptane, "Isopar E, H, G" (manufactured by ExxonMobil Chemical Co, Ltd.), or gasoline, kerosene, and the like), aromatic hydrocarbons (toluene, xylene and the like), halogenated hydrocarbons (methylene dichloride, ethylene dichloride, trichlene, monochlorobenzene and the like), or polar solvents described below.

As the polar solvent, mention may be made of, for example, alcohols (methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, dipropylene glycol monomethyl ether, polyethylene glycol monomethyl ether, polypropylene glycol, tetraethylene glycol, ethylene glycol monobutyl ether,

ethylene glycol monobenzyl ether, ethylene glycol monophenyl ether, methylphenyl carbinol, n-amyl alcohol, methylamyl alcohol, and the like), ketones (acetone, methyl ethyl ketone, ethyl butyl ketone, methyl isobutyl ketone, cyclohexanone and the like), esters (ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, butyl levulinate and the like), and others (triethyl phosphate, tricresyl phosphate, N-phenyl ethanolamine, N-phenyl diethanolamine and the like).

In addition, when the aforementioned organic solvent is insoluble in water, it can be used after being solubilized in water by means of surfactants and the like. When the developer contains an organic solvent, the concentration of the solvent is preferably less than 40% by weight from the perspective of safety and inflammability.

The developer of the invention can also contain, as the water-soluble polymeric compound, soybean polysaccharides, modified starches, gum arabic, dextrin, cellulose derivatives (e.g., carboxymethylcellulose, carboxyethylcellulose, methylcellulose and the like) and variants thereof, pullulan, polyvinyl alcohol and its derivatives, polyvinyl pyrrolidone, polyacrylamide and acrylamide copolymers, vinyl methyl ether/maleic anhydride copolymers, vinyl acetate/maleic anhydride copolymers, styrene/maleic anhydride copolymers, and the like.

For the soybean polysaccharides, any known ones can be used, and for example, the product marketed under the product name Soyafibe (manufactured by Fuji Oil Co., Ltd.) of various grades can be used. Those that can result in a 10% by weight aqueous solution hawing a viscosity in a range of 10 to 100 mPa/sec are preferably used.

For the modified starches, those known compounds can be used, or they can be prepared by a method of degrading starch obtained from com, potato, tapioca, rice, wheat and the like with acid or enzymes to products with the number of glucose residues per molecule in a range of 5 to 30, and adding oxypropylene thereto in an alkaline solution, and the like.

The water-soluble polymeric compound can be used in a combination of two or more species. The content of the water-soluble polymeric compound in the developer is preferably from 0.1 to 20% by weight, and more preferably from 0.5 to 10% by weight.

In addition to the above-mentioned compounds, the developer used in the invention may also contain preservative, chelate compound, anti-foaming agent, organic acid, inorganic acid, inorganic salt and the like.

For the preservative, phenol or its derivatives, formalin, imidazole derivatives, sodium dihydroacetate, 4-isothiazolin-3-one, benzoisothiazolin-3-one, benzotriazole derivatives, amidine guanidine derivatives, quaternary ammonium salts, derivatives of pyridine, quinoline, guanidine and the like, diazine, triazole derivatives, oxazole, oxazole derivatives, nitrobromoalcohol-based 2-bromo-2-nitropropan-1,3-diol, 1,1-dibromo-1-nitro-2-ethanol, 1,1-dibromo-1-nitro-2-propanol, and the like can be preferably used.

For the chelate compound, examples may include ethylenediamine tetraacetic acid, potassium salt and sodium salt thereof, diethylenetriamine pentaacetic acid, potassium salt and sodium salt thereof, triethylenetetramine hexaacetic acid, potassium salt and sodium salt thereof, hydroxyethyl ethylenediamine triacetic acid, potassium salt and sodium salt thereof, nitrilotriacetic acid, sodium salt thereof, organophosphonic acids such as 1-hydroxyethan-1,1-diphosphonic acid, potassium salt and sodium salt thereof, aminotri(methylenephosphonic acid), potassium salt and sodium salt thereof, or phosphonoalkane tricarboxylic acids. Instead of the sodium salt and potassium salt of the aforementioned cheating agents, organic amine salts are also effective.

As the anti-foaming agent, common silicones of the self-emulsifying type and emulsifying type, and nonionic surfactant and the like compounds with an HLB value of 5 or less can be used. Among them, silicone anti-foaming agents are preferred, and of these, the compounds of the emulsifying dispersant type and solubilizing type can all be used.

As the organic acid, citric acid, acetic acid, oxalic acid, malonic acid, salicylic acid, caprylic acid, tartaric acid, malic acid, lactic acid, levulinic acid, p-toluene sulfonic acid, xylene sulfonic acid, phytic acid, organophosphonic acid and the like may be mentioned. The organic acid can be used in the form of its alkali metal salt or ammonium salt. Its content in the developer is preferably from 0.01 to 5% by weight.

As the inorganic acid and inorganic salts, mention may be made of phosphoric acid, metaphosphoric acid, monobasic ammonium phosphate, dibasic ammonium phosphate, monobasic sodium phosphate, dibasic sodium phosphate, monobasic potassium phosphate, dibasic potassium phosphate, sodium tripolyphosphate, potassium pyrrolinate, sodium hexametaphosphoric acid, magnesium nitrate, sodium nitrate, potassium nitrate, ammonium nitrate, sodium sulfate, potassium sulfate, ammonium sulfate, sodium sulfite, ammonium sulfite, sodium hydrogen sulfate, nickel sulfate and the like. Its content in the developer is preferably from 0.01 to 5% by weight.

The development treatment of the invention using a non-alkaline aqueous solution can be carried out suitably by means of an automatic treating machine equipped with a supplying unit of the developer and an element for friction finishing. The automatic treating machine may be exemplified by the automatic treating machine as described in the publications of JP-A Nos. 2-220061 and 60-59351, by which the image-recorded lithographic printing plate precursor is subjected to friction finish while being transferred; the automatic treating machine as described in the specifications of USP Nos. 5148746 and 5568768 and GBP No. 2297719, by which the image-recorded lithographic printing plate precursor set up on a cylinder is subjected to friction finish while rotating the cylinder, and the like. It is also arbitrarily

possible to subject the friction-finished lithographic printing plate of the invention subsequently to optional washing, drying and desensitizing treatment.

The temperature of the developer may be selected arbitrarily, but it is preferably from 10°C to 50°C.

In the platemaking process for the lithographic printing plate used in the phatemaking method of the invention, the whole surface may be heated before exposure, during exposure, or during the time interval between exposure and development, if necessary. Such heating can be advantageous in that the image forming reaction in the photosensitive layer is accelerated to improve the sensitivity or the press life, or to stabilize the sensitivity. It is also effective to carry out post-heating or exposure of the whole surface of the image after development, under the purpose of improving the image strength and the press life. Usually, heating before development is preferably carried out under mild conditions of 150°C or less temperatures. When the temperature is too high, there occurs a problem of even the unexposed area being masked. The heating after development may be carried out under severe conditions. The temperature is typically in a range of 200 to 500°C. When the temperature is low, sufficient image intensification cannot be achieved, and when the temperature is too high, there are problems such as deterioration of the support, thermal decomposition of the image area, and the like.

<On-press development treatment>

As the method of printing without going through the process of development treatment, mention may be made specifically of a method of exposing a lithographic printing plate precursor to light and then printing with the plate precursor mounted on the printing press, without going through the process of development treatment; a method of mounting a lithographic printing plate precursor on the printing press and then printing as such by exposing the plate precursor to light on the printing press; and the like.

The expose area in the image recording layer of the imagewise exposed lithographic printing plate precursor becomes insoluble by curing upon polymerization. When printing is carried out by supplying an oily ink and an aqueous component to the exposed lithographic printing plate precursor, without carrying out the development treatment such as wet development treatment process, the uncured image recording layer at the unexposed area is removed by dissolution or dispersion in the oily ink and/or the aqueous component, thus the hydrophilic surface of the support in the aforementioned area being exposed. Meanwhile, in the exposed area, there remains the image recording layer cured by polymerization, and the area forms the oily ink-receiving area (image area) having oleophilic surface.

As the result, the aqueous component is adhered to the exposed hydrophilic surface, whereas the oily ink is adhered to the image recording layer of the exposed area, thus initiating printing. Here, the first to be supplied onto the plate precursor surface may be any of the aqueous component and the oily ink, but it is preferable to supply the oily ink first in order to prevent contamination of the aqueous component by the image recording layer at the unexposed area. For the aqueous component and oily ink, conventional fountain solutions and printing inks for lithographic printing are used.

As such, the lithographic printing plate precursor is developed on-press on the offset printing press to be used in multiple printing.

[Lithographic printing plate precursor]

The lithographic printing plate precursor used in the invention has an image recording layer containing (A) a polymerization initiator and (B) a polymeric compound on a support, and has photosensitivity in a wavelength region of from 250 nm to 420 nm.

Hereinafter, the elements constituting the lithographic printing plate precursor will be explained.

<(A) Polymerization initiator>

The polymerization initiator as used in the invention is a compound which generates a radical by light energy, and initiates and accelerates polymerization of the compounds having polymerizable unsaturated group, and in particular, it is a compound which generates a radical by absorbing light in the region of from 250 nm to 420 nm when used alone or in a combination with the sensitizing agent that will be described below. For such photoradical generator, a known polymerization initiator or a compound having bonds with small bond dissociation energies may be suitably selected and used.

Also, since the intensity of the emission spectrum of a white light is strong in the visible region over 400 nm, and the polymerization initiator having sufficient photosensitivity in that region is susceptible to have fogging under the white light, the bands of absorption maximum for the initiator and sensitizer are preferably selected to extend up to 400 nm.

Such radical-generating compound may be exemplified by organic halogen compounds, carbonyl compounds, organic peroxides, azo-based compounds, azide compounds, metallocene compounds, hexaaryl biimidazole compounds, organic boron compounds, disulfone compounds, oxime ester compounds and onium compounds.

As the organic halogen compound, mention may be made specifically of the compounds described in Wakabayashi, et al., "Bull. Chem. Soc. Japan" 42, 2924 (1969), the specification of USP No. 3,905,815, the publications of JP-B No. 46-4605, JP-A Nos. 48-36281, 53-133428, 55-32070, 60-239736, 61-169835, 61-169837, 62-58241, 62-212401, 63-70243 and 63-298339, and M.P.Hutt, "Journal of Heterocyclic Chemistry" 1 (No. 3) (1970). Among these, the oxazole and S-triazine compounds with substituted trihalomethyl group are preferred.

More preferably, mention may be made of the s-triazine derivatives in which at least one mono-, di- or trihalogen-substituted methyl group is attached to the s-triazine ring, specifically for example, 2,4,6-tris(monochloromethyl)-s-triazine, 2,4,6-tris(dichloromethyl)-s-triazine, 2,4,5-tris(trichloromethyl)-s-triazine, 2-methyl-4,6-bis(trichloromethyl)-s-triazine, 2-n-propyl-4,6-bis(trichloromethyl)-s-triazine, 2-($\alpha$,$\alpha$,$\beta$-trichloroethyl)-4,6-bis(trichloromethyl)-s-triazine, 2-(3,4-epoxyphenyl)-4,6-bis(trichloromethyl)-s-triazine, 2-[1-(p-methoxyphenyl)-2,4-butadienyl]-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(p-i-propyl oxysyryl)-4,6-bis(trichloromethylo)-s-triazine, 2-(p-tolyl)-4,6-bis(trichloromethyl)-s-triazine, 2-(4-methoxynaphthyl)-4,6-bis(trichloromethyl)-s-triazine, 2-phenylthio-4,6-bis(trichloromethyl)-s-triazine, 2-benzylthio-4,6-bis(trichloromethyl)-s-triazine, 2,4,6-tris(dibromoomethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine, or the following compounds and the like.

(I)-1

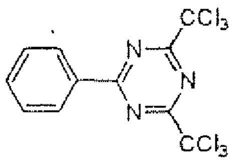

(I)-2

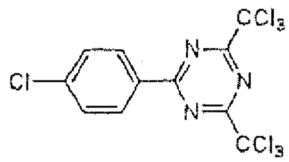

(I)-3

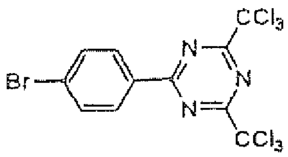

(I)-4

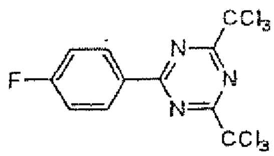

(I)-5

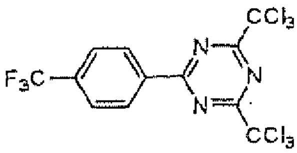

(I)-6

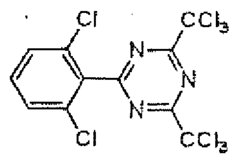

(I)-7

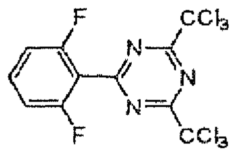

(I)-8

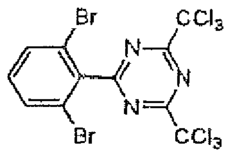

(I)-9

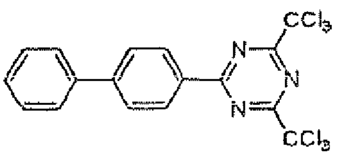

(I)-10

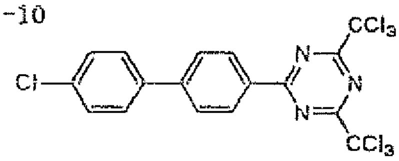

(I)-11

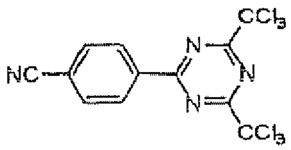

(I)-12

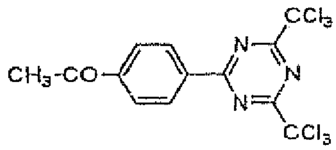

(I)-13

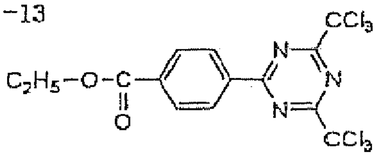

(I)-14

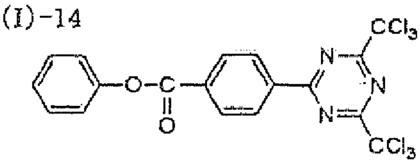

(I)-15

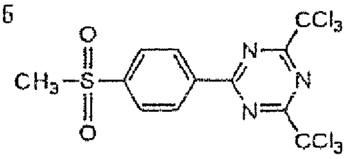

(I)-16

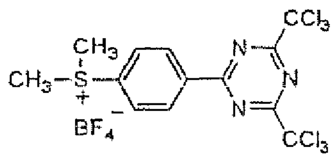

(I)-17

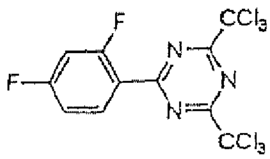

(I)-18

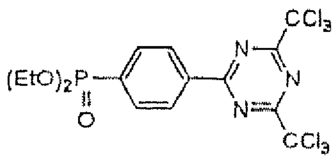

(I)-19

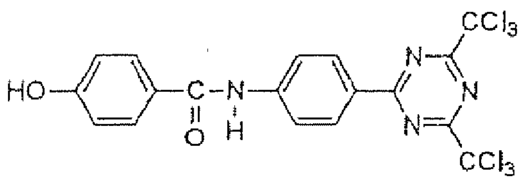

(I)-20

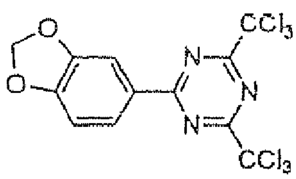

(I)-21

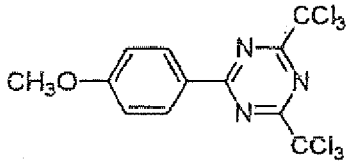

(I)-22

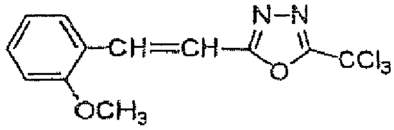

(I)-23

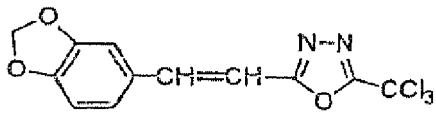

(I)-24

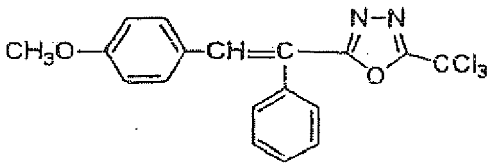

(I)-25

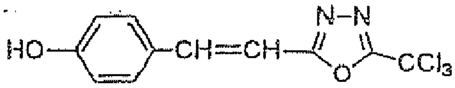

(I)-26

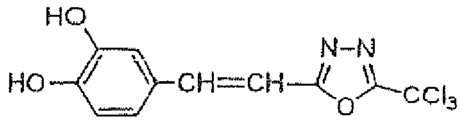

(I)-27

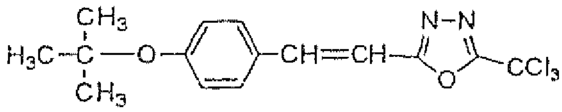

As the carbonyl compound, mention may be made of benzophenone derivatives such as benzophenone, Michler's ketone, 2-methylbenzophenone, 3-methylbenzophenone, 4-methylbenzophenone, 2-chlorobenzophenone, 4-bromobenzophenone, 2-carboxybenzophenone and the like; acetophenone derivatives such as 2,2-dimethoxy-2-phenylacetophenone, 2,2-diethoxyacetophenone, 1-hydroxycyclohexylphenyl ketone, (-hydroxy-2-methylphenyl propanone, 1-hydroxy-1-methylethyl-(p-isopropylphenyl) ketone, 1-hydroxy-7-(p-dodecylphenyl) ketone, 2-methyl-(4'-(methylthio)phenyl)-2-morpholino-1-propanone, 1,1,1-trichloromethylo-(p-butylphenyl) ketone and the like; thioxantone derivatives such as thioxantone, 2-ethyl thioxantone, 2-isopropyl thioxantone, 2-chlorothioxantone, 2,4-dimethyl thioxantone, 2,4-diethyl thioxantone, 2,4-diisopropyl thioxantone and the like; and benzoin acid ester derivatives such as ethyl p-dimethylaminobenzoic acid, ethyl p-diethylaminobenzoic acid and the like.

As the azo-based compound, for example, the azo compounds described in the publication of JP-A No. 8-108621 can be used.

As the organic peroxide, mention may be made of, for example, trimethylcyclohexanone peroxide, acetylacetone peroxide, 1,1-bis(tert-butylperoxy)-3,3,5-trimethylcyclohexane, 1,1-bis(tert-butylperoxy)cyclohexane, 2,2-bis(tert-butylperoxy)butane, tert-butyl hydroperoxide, cumene hydroperoxide, diisopropylbenzene hydroperoxide, 2,5-dimethylhexane-2,5-dihydroperoxide, 1,1,3,3-teuamethylbutyl hydroperoxide, tert-butylcumyl peroxide, dicumyl peroxide, 2,5-dimethyl-2,5-di(tert-butylperoxy)hexane, 2,5-oxanoyl peroxide, peroxysuccinic acid, benzoyl peroxide, 2,4-dichlorobenzoyl peroxide, diisopropyl peroxydicarbonate, di-2-ethylhexyl peroxydicarbonate, di-2-ethoxyethyl peroxydicarbonate, dimethoxyisopropyl peroxycarbonate, di-(3-methyl-3-methoxybutyl) peroxydicarbonate, tert-butyl peroxyacetate, tert-butyl peroxypivalate, tert-butyl peroxyneodecanoate, tert-butyl peroxyoctanoate, tert-butyl peroxylaurate, tosyl carbonate, 3,3',4,4'-tetra(t-butyl peroxycarbonyl)benzophenone, 3,3',4,4'-tetra-(t-hexyl peroxycarbonyl)benzophenone, 3,3',4,4'-tetra-(p-isopropylcumyl peroxycarbonyl)benzophenone, carbonyl di(t-butylpeeroxy dihydrogen diphthalate), carbonyl di(t-hexylperoxy dihydrogen diphthalate) and the like.

As the metallocene compound, mention may be made of the various titanocene compounds as described in the publications of JP-A Nos. 59-152396, 61-151197, 63-41484, 2-249, 2-4705 and 5-83588, for example, di-cyclopentadienyl-Ti-bis-phenyl di-cyclopentadienyl-Ti-bis-2,6-di-fluorophen-1-yl, di-cyclopentadienyl-Ti-bis-2,4-di-fluorophen-1-yl, di-cyclopentadienyl-Ti-bis-2,4,6-trifluoropheny-1l, di-cyclopentadienyl-Ti-bis-2,3,5,6-tetrafluorophen-1-yl, di-cyclopentadienyl-Ti-bis-2,3,4,5,6-pentafluorophen-1-yl, di-methylcyclopentadienyl-Ti-bis-2,6-di-fluorophen-yl, di-methylcyclopentadienyl-Ti-bis-2,4,6-trifluorophen-1-yl, di-methylcyclopenladienyl-Ti-bis-2,3,5,6-tetrafluorophen-1-yl, di-methylcyclopenladienyl-Ti-bis-2,3,4,5,6-pentafluorophen-1-yl, the iron-arene complex described in the publications of JP-A Nos. 1-304453 and 1-152109, and the like.

As the hexaaryl biimidazole compound, mention may be made of, for example, various compounds described in the publication of JP-B No. 6-29285, and the specifications of USP Nos. 3,479,185, 4,311,783 and 4,622,286; in particular, 2,2'-bis(o-chlorophenyl)-4,4',5,5'-tetraphenyl biimidazole, 2,2'-bis(o-bromophenyl)-4,4',5,5'-tetraphenyl biimidazole, 2,2'-bis(o,p-dichlorophenyl)-4,4',5,5'-tetraphenyl biimidazole, 2,2'-bis(o-chlorophenyl)-4,4',5,5'-tetra(m-methoxyphenyl) biimidazole, 2,2'-bis(o,o'-dichlorophenyl)-4,4',5,5'-tetraphenyl biimidazole, 2,2'-bis(o-nitrophenyl)-4,4',5,5'-tetraphenyl biimidazole, 2,2'-bis(o-methylphenyl)-4,4',5,5'-tetraphenyl biimidazole, 2,2'-bis(o-trifluorophenyl)-4,4',5,5'-tetraphenyl biimidazole and the like.

As the organic boron compound, mention may be made of, for example, the organic boric acid salts as described in the publications of JP-A Nos. 62-143044, 62-150242, 9-188685, 9-188686, 9-188710, 2000-131837 and 2002-107916, the specification of JP 2764769, the publication of JP-A No. 2002-116539 and Kunz, Martin, "Rad Tech '98. Proceeding April 19-22, 1998, Chicago"; the organic boron-sulfonium complexes or the organic boron-oxosulfonium complexes as described in the publications of JP-A Nos. 6-157623, 6-175564 and 6-175561; the organic boron-iodonium complexes as described in the publications of JP-A Nos. 6-175554 and 6-175553; the organic boron-phosphonium complexes as described in the publication of JP-A No. 9-188710; the organic boron-transition metal coordination complexes as described in the specifications of JP-A Nos. 6-348011, 7-128785, 7-140589, 7-306527 and 7-292014; and the like.

As the disulfone compounds, the compounds as described in the specifications of JP-A Nos. 61-166544 and 2003-328465, and the others may be mentioned.

As the oxime ester compound, mention may be made of the compounds described in J.C.S. Perkin II (1979) 1653-1660, J.C.S. Perkin II (1979) 156-162, Journal of Photopolymer Science and Technology (1995) 202-232 and in the publication of JP-A No. 2000-66385, the compounds described in the publication of JP-A No. 2000-80068, and specifically the compounds represented by the following structural formulas:

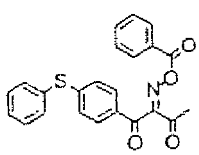 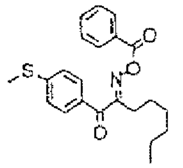 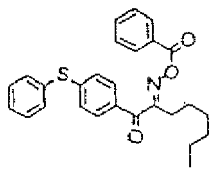 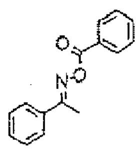 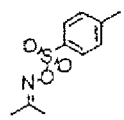

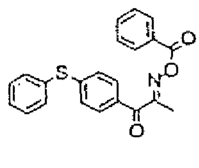 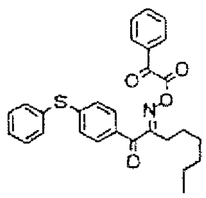 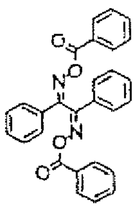 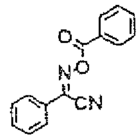 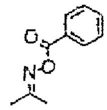

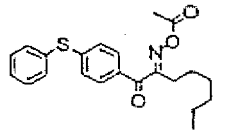 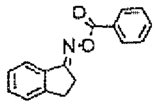 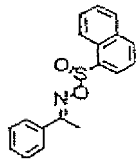 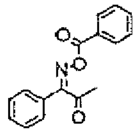 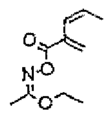

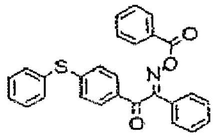 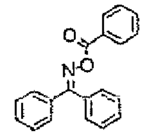 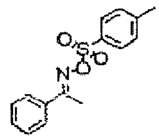 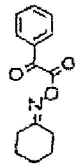 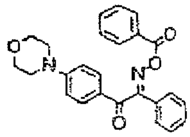

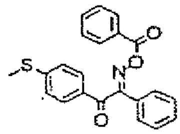 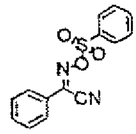

As the onium salt compound, mention may be made of, for example, the diazonium salts as described in S.I. Schlesinger, Photogr. Sci. Eng., 18, 387(1974) and T.S. Bal et al., Polymer, 21, 423 (1980); the ammonium salts as described in the specification of USP No. 4,069,055, the publication of JP-A No. 4-365049 and the like; the phosphonium salts as described in the specifications of USP Nos. 4,069,055 and 4,069,056; the iodonium salts as described in the specifications of EP 104,143, USP Nos. 339,049 and 410,201 and the publications of JP-A Nos. 2-150848 and 2-296514; the sulfonium salts as described in tie specifications of EP 370,693, EP 390,214, EP 233,567, EP 297,443, EP 297,442, USP Nos. 4,933,377, 161,811, 410,201, 339,049, 4,760,013, 4,734,444, 2,833,827, DE 2,904,626, DE 3,604,580 and DE 3,604,581; the celenonium salt as described in J.V Crivello et al., Macromolecules, 10(6), 1307 (1977) and J.V. Crivello et al., J. Polymer Sci., Polymer Chem. Ed., 17, 1047 (1979); the arsonium salt as described in C.S. Wen et al., Teh, Proc. Conf. Rad. Curing ASIA, p478, Tokyo, Oct (1988); and the like.

According to the invention, these onium salts are not acid-generating agents, and they function as ionic radical polymerization initiators.

The onium salts that can be used very suitably in the invention are the onium salts represented by the following formulas (RI-I) to (RI-III):

$$Ar_{11}-\overset{+}{N}\equiv N \qquad Z_{11}^{-} \qquad (RI-I)$$

$$Ar_{21}-\overset{+}{I}-Ar_{22} \qquad Z_{21}^{-} \qquad (RI-II)$$

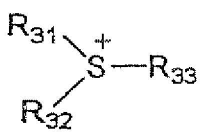 (RI-III)

In Formula (RI-I), $Ar_{11}$ represents an aryl group having up to 20 carbon atoms and optionally having 1 to 6

substituents, wherein preferable substituents may include an alkyl group having 1 to 12 carbon atoms, an alkenyl group having 1 to 12 carbon atoms, an alkynyl group having 1 to 12 carbon atoms, an aryl group having 1 to 12 carbon atoms, an alkoxy group having 1 to 12 carbon atoms, an aryloxy group having 1 to 12 carbon atoms, a halogen atom, an alkylamino group having 1 to 12 carbon atoms, a dialkylamino group having 1 to 12 carbon atoms, an alkylamido group or arylamido group having 1 to 12 carbon atoms, a carbonyl group, a carboxyl group, a cyano group, a sulfonyl group, a thioalkyl group having 1 to 12 carbon atoms, and a thioaryl group having 1 to 12 carbon atoms. $Z_{11}$ represents a monovalent anion, which may be exemplified specifically by a halogen ion, a perchlorate ion, a hexafluorophosphate ion, a tetrafluoroborate ion, a sulfonate ion, a sulfinate ion, a thiosulfonate ion, and a sulfate ion. Among these, preferred are the peroxychlorate ion, hexafluorophosphate ion, tetrafluoroborate ion, sulfonate ion and sulfinate ion, in the aspect of stability.

In Formula (RI-II), $Ar_{21}$ and $Ar_{22}$ each independently represent an aryl group having up to 20 carbon atoms and optionally having 1 to 6 substituents, wherein preferred substituents may include an alkyl group having 1 to 12 carbon atoms, an alkenyl group having 1 to 12 carbon atoms, an alkynyl group having 1 to 12 carbon atoms, an aryl group having 1 to 12 carbon atoms, an alkoxy group having 1 to 12 carbon atoms, an aryloxy group having 1 to 12 carbon atoms, a halogen atom, an alkylamino group having 1 to 12 carbon atoms, a dialkylamino group having 1 to 12 carbon atoms, an alkylamido group or arylamido group having 1 to 12 carbon atoms, a carbonyl group, a carboxyl group, a cyano group, a sulfonyl group, a thioalkyl group having 1 to 12 carbon atoms, and a thioaryl group having 1 to 12 carbon atoms. $Z_{21}^-$ represents a a monovalent anion and may be exemplified specifically by a halogen ion, a perchlorate ion, a hexafluorophosphate ion, a tetrafluoroborate ion, a sulfonate ion, a sulfinate ion, a thiosulfonate ion, and a sulfate ion. Among these, preferred are the perchlorate ion, hexafluorophosphate ion, tetrafluoroborate ion, sulfonate ion, sulfinate ion and carbonate ion in the aspects of stability and reactivity.

In Formula (RI-III), $R_{31}$, $R_{32}$ and $R_{33}$ each independently represent an aryl group, alkyl group, alkenyl group or alkynyl group having up to 20 carbon atoms and optionally having 1 to 6 substituents. Among these, preferred is the aryl group in the aspects of reactivity and stability. The substituent may include an alkyl group having 1 to 12 carbon atoms, an alkenyl group having 1 to 12 carbon atoms, an alkynyl group having 1 to 12 carbon atoms, an aryl group having 1 to 12 carbon atoms, an alkoxy group having 1 to 12 carbon atoms, an aryloxy group having 1 to 12 carbon atoms, a halogen atom, an alkylamino group having 1 to 12 carbon atoms, a dialkylamino group having 1 to 12 carbon atoms, an alkylamido group or arylamido group having 1 to 12 carbon atoms, a carbonyl group, a carboxyl group, a cyano group, a sulfonyl group, a thioalkyl group having 1 to 12 carbon atoms, and a thioaryl group having 1 to 12 carbon atoms. $Z_{31}^-$ represents a monovalent anion and may be exemplified specifically by a halogen ion, a perchlorate ion, a hexafluorophosphate ion, a tetrafluoroborate ion, a sulfonate ion, a sulfinate ion, a thiosulfonate ion, and a sulfate ion. Among these, preferred are the perchlorate ion, hexafluorophosphate ion, tetrafluoroborate ion, sulfonate ion, sulfinate ion and carbonate ion, in the aspects of stability and reactivity. More preferred is the carbonate ion as described in the publication of JP-A No. 2001-343742, and particularly preferred is the carbonate ion as described in the publication of JP-A No. 2002-148790.

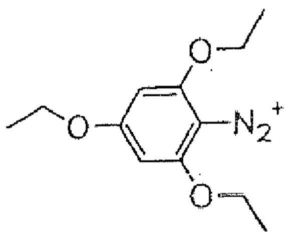 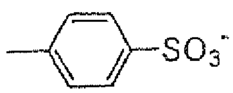 (N-1)

$PF_6^-$ (N-2)

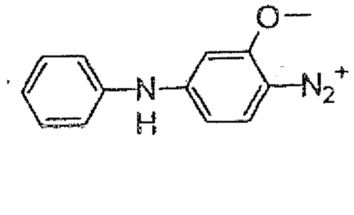 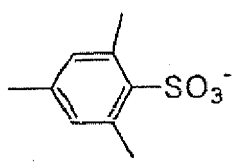 (N-3)

$ClO_4^-$ (N-4)

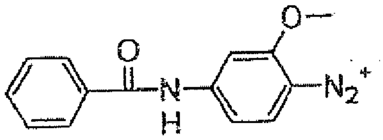

$CF_3SO_3^-$ (N-5)

$BF_4^-$ (N-6)

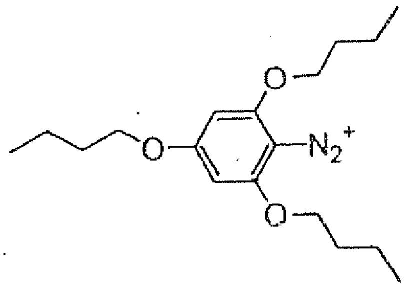

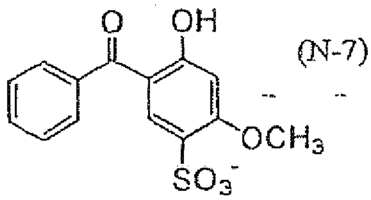

(N-7)

$ClO_4^-$ (N-8)

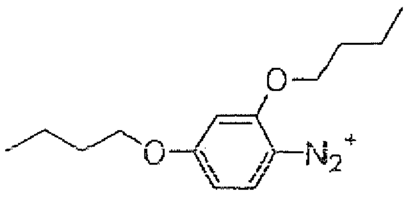

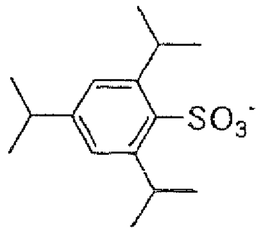

(N-9)

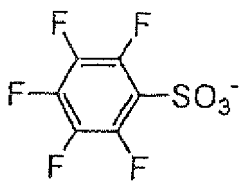

(N-10)

$PF_6^-$ (N-11)

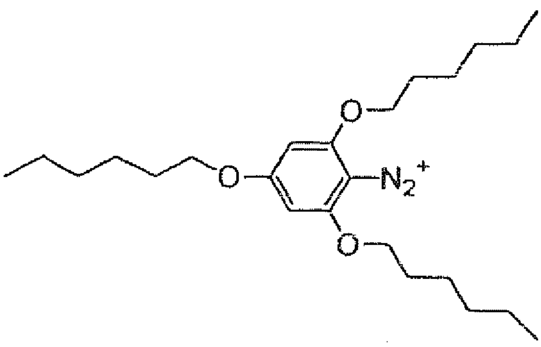

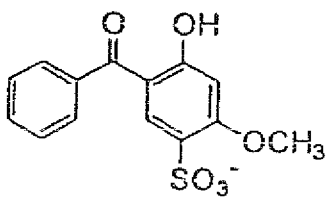

(N-12)

$ClO_4^-$ (N-13)

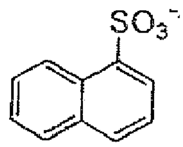

(N-14)

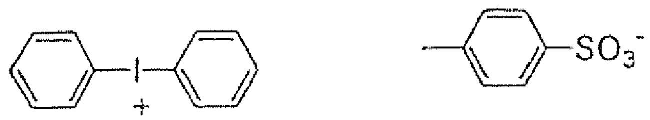

(I-1)

$PF_6^-$ (I-2)

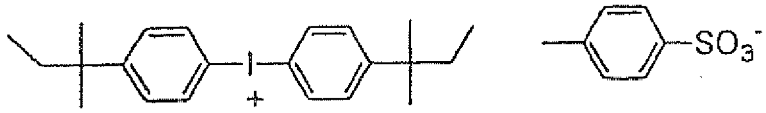

(I-3)

$ClO_4^-$ (I-4)

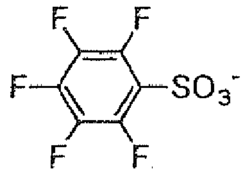

(I-5)

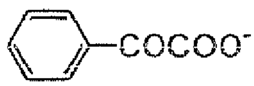

(I-6)

$CF_3SO_3^-$ (I-7)

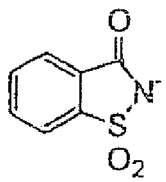

(I-8)

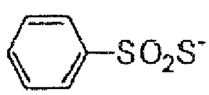

(I-9)

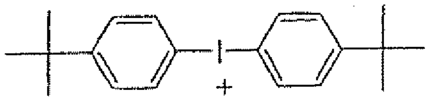 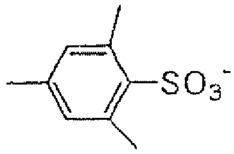 (I-10)

$ClO_4^-$ (I-11)

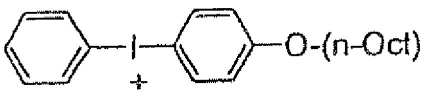 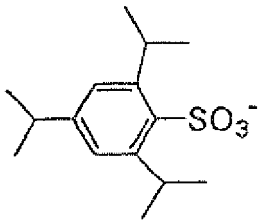 (I-12)

$CF_3COO^-$ (I-13)

$CF_3SO_3^-$ (I-14)

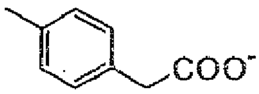 (I-15)

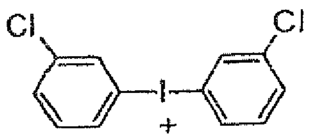 $BF_4^-$ (I-16)

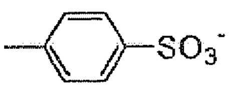 (I-17)

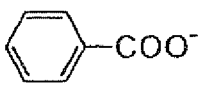 (I-18)

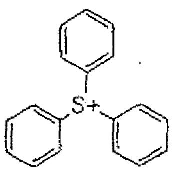

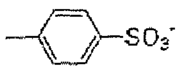 (S-1)

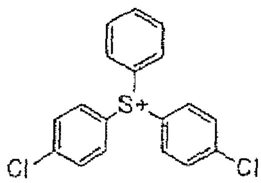

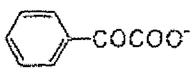 (S-10)

$PF_6^-$ (S-2)

$ClO_4^-$ (S-3)

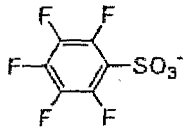

(S-4)

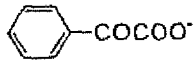

(S-5)

$CF_3SO_3^-$ (S-6)

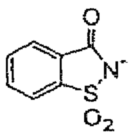

(S-7)

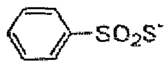

(S-8)

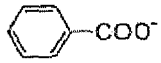

(S-9)

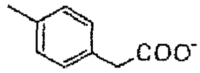

(S-11)

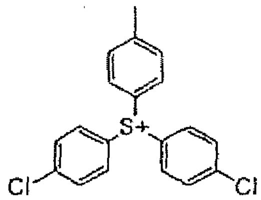

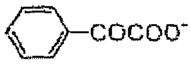

(S-12)

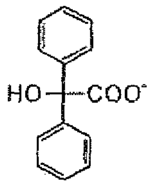

(S-13)

$BF_4^-$ (S-14)

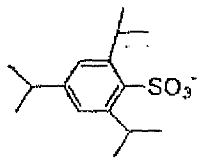

(S-15)

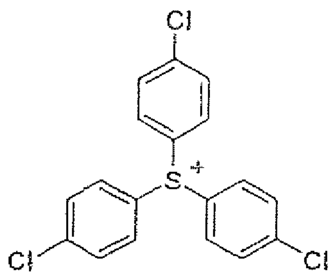

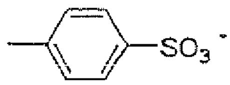

(S-16)

$PF_6^-$ (S-17)

$ClO_4^-$ (S-18)

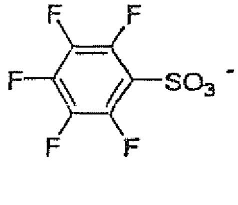

(S-19)

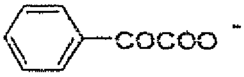 (S-20)

$CF_3SO_3^-$ (S-21)

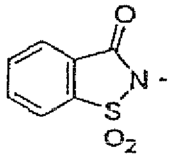 (S-22)

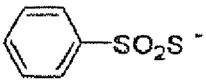 (S-23)

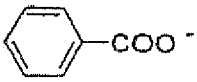 (S-24)

For the polymerization initiator, although not intended to be limited to the above-described compounds, the triazine-based initiators, organic halogen compounds, oxime ester compounds, diazonium salts, iodonium salts and sulfonium salts are more preferred in the aspects of reactivity and stability, and from the viewpoint that a large quantity of radicals can be generated by exposure in a short period of time.

Moreover, the polymerization initiators involving these triazine-based initiators, organic halogen compounds, oxime ester compounds, diazonium salts, iodonium salts and sulfonium salts are preferably used in a combination with a sensitizer. When used in a combination with a sensitizer, the photopolymerization rate can be enhanced.

As specific examples of such sensitizer, mention may be made of benzoin, benzoin methyl ether, benzoin ethyl ether, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-t-butyl-9,10-anthraquinone, 2,6-dichloro-9,10-anthraquinone, xanthone, 2-methylxanthone, 2-methoxyxanthone, thioxantone, benzyl, dibenzalacetone, p-(dimethylamino)phenylstyryl ketone, p-(dimethylamino)phenyl p-methylstyryl ketone, benzophenone, p-(dimethylamino)benzophenone (or Michler's ketone), p-(diethylamino)benzophenone, benzanthrone and the like.

Further, preferred sensitizer according to the invention may include the compound represented by Formula (I) as described in the publication of JP-B No. 51-48516.

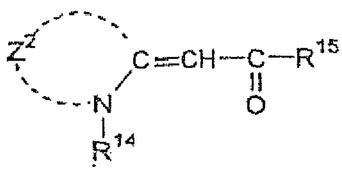 (I)

wherein, $R^{14}$ represents an alkyl group (e.g., a methyl group, an ethyl group, a propyl group, etc.) or a substituted alkyl group (e.g., a 2-hydroxyethyl group, a 2-methoxyethyl group, a carboxymethyl group, a 2-carboxyethyl group, etc.), and $R^{15}$ represents an alkyl group (e.g., a methyl group, an ethyl group, etc.) or an aryl group (e.g., a phenyl group, a p-hydroxyphenyl group, a naphthyl group, a thienyl group, etc.).

$Z^2$ represents a non-metallic group necessary for the formation of heterocyclic nuclei containing nitrogen which are usually used as cyanine dye, for example, benzothiazoles (benzothiazole, 5-chlorobenzothiazole, 6-chlorobenzothiazole, etc.), naphthothiazoles (α-naphthothiazole, β-naphthothiazole, ctc.), benzoselenazoles (benzoselenazole, 5-chlorobenzoselenazole, 6-methoxybenzoselenazole, etc.), naphthoselenazoles (α-naphthoselenazole, β-naphthoselenazole, etc.), benzoxazoles (benzoxazole, 5-methylbenzoxazole, 5-phenylbenzoxazole, etc.), and naphthoxazoles (α-naphthoxazole, β-naphthoxazole, etc.).

Specific examples of the compound represented by Formula (I) are those having the chemical structures combining these $Z^2$, $R^{14}$ and $R^{15}$, and most of them are known in the art. Therefore, the compound can be suitably selected and used from those known ones. Preferred sensitizer of the invention may also include the merocyanine dyes as described in the publication of JP-B No. 5-47095, and the ketocoumarin-based compounds represented by the following Formula (II):

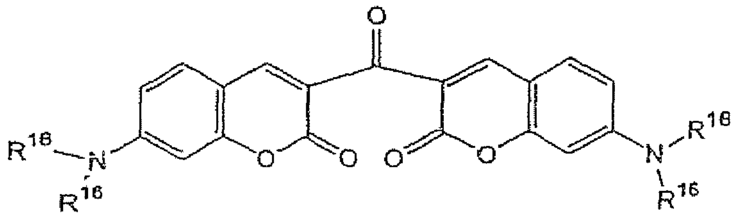

(II)

wherein $R^{16}$ represents an alkyl group such as a methyl group, an ethyl group and the like.

As the sensitizer, use can be also made of the merocyanine-based dyes as described in the publication of JP-A No. 2000-147763. Specifically, the following compounds may be included.

D-1

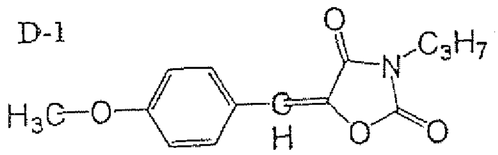

D-6

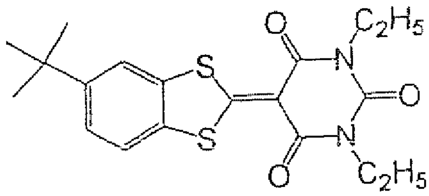

D-2

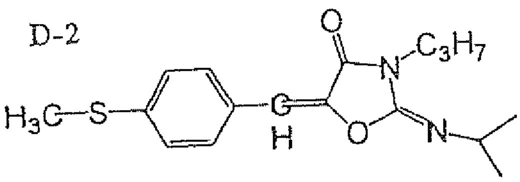

D-7

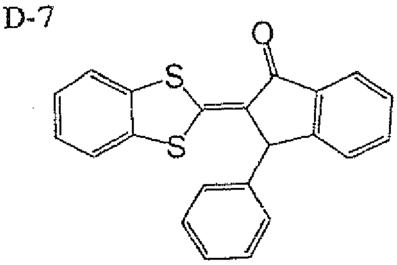

D-3

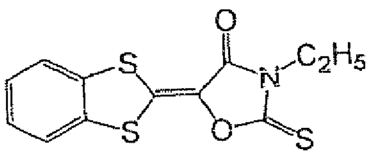

D-8

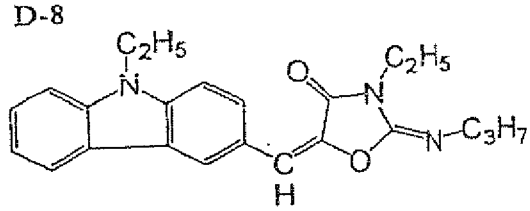

D-4

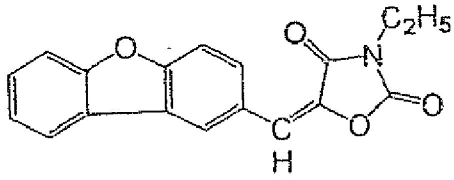

D-9

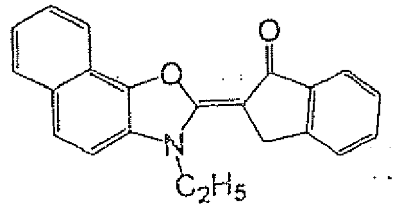

D-5

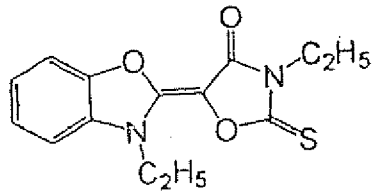

Such polymerization initiator and sensitizer can be respectively added in a proportion of preferably from 0.1 to 50% by weight, more preferably from 0.5 to 30% by weight, and particularly preferably from 0.8 to 20% by weight, relative to the total solids content constituting the image recording layer. Within these ranges, good sensitivity and good anti-contamination properly in the non-image area during printing can be achieved. These polymerization initiators may be used alone or in a combination of two or more species. Also, these polymerization initiators may be either added to the same layer together with other components or added to another layer provided separately.

<(B) Polymerizable compound>

The polymerizable compound that can be used in the invention is an addition-polymerizable compound having at least one ethylenically unsaturated double bond and is selected from the compounds having at least one, preferably two or more, ethylenic unsaturated bonds. The family of such compounds is well known in the pertinent art, and they can be used in the invention without particular limitation. They are, for example, in the chemical form of a monomer, a prepolymer, namely, a dimer, a trimer and an oligomer, or mixtures thereof and copolymers thereof, and the like. Examples of such a monomer and a copolymer thereof may include unsaturated carboxylic acids (e.g., acrylic acid, methacrylic acid, itaconic acid, crotonic acid, isocrotonic acid, maleic acid, etc.), and esters and amides thereof. Preferably, esters of unsaturated carboxylic acids and aliphatic polyhydric alcohol compounds, and amides of unsaturated carboxylic acids and aliphatic polyvalent amine compounds are used. Further, the addition products of unsaturated carboxylic acid esters or amides having nucleophilic substituents such as a hydroxyl group, an amino group, a mercapto group and the like, with monofunctional or polyfunctional isocyanates or epoxides, and the dehydration-condensation products thereof with monofunctional or polyfunctional carboxylic acids are also suitably used. Also suitably used are the addition products of unsaturated carboxylic acid esters or amides having electrophilic substituents such as an isocyanate group, an epoxy group and the like with monofunctional or polyfunctional alcohols, amines and thiols, and the substitution products of unsaturated carboxylic esters or amides having releasable substituents such as a halogen group, a tosyloxy group and the like with monofunctional or polyfunctional alcohols, amines and thiols. Further, as a distinctive example, it is also possible to use a group of compounds that are substituted by unsaturated phosphonic acids, styrene, vinyl ether and the like, instead of the aforementioned unsaturated carboxylic acids.

Specific examples of the monomeric ester of an aliphatic polyhydric alcohol compound and an unsaturated carboxylic acid may include, for an acrylic ester, ethylene glycol diacrylate, triethylene glycol diacrylate, 1,3-butanediol diacrylate, tetramethylene glycol diarylate, propylene glycol diacrylate, neopentyl glycol diacrylate, trimethylolpropane triacrylate, trimethylolpropane tri(acryloyl oxypropyl)ether, trimethylolethane triacrylate, hexanediol diacrylate, 1,4-cycloheane diol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyl oxyethyl)isocyanurate, polyester acrylate oligomer, EO-modified isocyanuric triacrylate, and the like.

For a methacrylic ester, mention may be made of tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol

hexamethacrylate, sorbitol trimethacrylate, sorbitol tetramethacrylate, bis[p-(3-methacryloxy-2-hydroxypropoxy)phenyl] dimethylmethane, bis-[p-(methacryloxyethoxy)phenyl] dimetylmethane and the like.

For an itaconic ester, there can be found ethylene glycol diitaconate, propylene glycol diitaconate, 1,3-butanediol diitaconate, 1,4-butanediol diitaconate, tetramethylene glycol diitaconate, pentaerythritol diitaconate, sorbitol tetraitaconate and the like. As a crotonic ester, there can be found ethylene glycol dicrotonate, tetramethylene glycol dicrotonate, pentaerythritol dicrotonate, sorbitol tetradicrotonate and the like. For an isocrotonic ester, there can be found ethylene glycol diisocrotonate, pentaerythritol diisocrotonate, sorbitol tetradiisocrotonate and the like. For a maleic ester, mention may be made of ethylene glycol dimalate, triethylene glycol dimalate, pentaerythritol dimalate, sorbitol tetramalate and the like.

Other examples of such ester that are also very suitably used may include, for example, the aliphatic alcohol-based esters as described in JP-B No. 51-47334 or 57-196231, those having the aromatic skeleton as described in JP-A No. 59-5240, 59-5241 or 2-226149, or those containing amino groups as described in JP-A No. 1-165613. Further, the above-described monomeric esters may be also used as mixtures.

Specific examples of the monomeric amide of an aliphatic polyvalent amine compound and of unsaturated carboxylic acid may include methylenebis-acrylamide, methylenebis-methacrylamide, 1,6-hexamethylenebis-acrylamide, 1,6-hexamethylenebis-methacrylamide, diethylenetriamine trisacrylamide, xylenebisacrylamide, xylenebismethacrylamide and the like. Other preferred examples of such amide-based monomer may include those having the cyclohexylene structure as described in JP-B No. 54-21726.

Further, also preferred are the urethane-based addition-polymerizable compounds prepared from the addition reaction between an isocyanate group and a hydroxyl group, and specific examples thereof may include, for example, the vinyl urethane compounds containing two or more polymerizable vinyl groups in a molecule, which are prepared by adding a vinyl monomer containing a hydroxyl group as represented by the following Formula (III), to a polyisocyanate compound having two or more isocyanate groups in a molecule as described in the publication of JP-B No. 48-41708, and the like:

$$CH_2{=}C(R4)COOCH_2CH(R5)OH \qquad (III)$$

wherein R4 and R5 represent H or $CH_3$.

In addition, also preferred are the urethane acrylates as described in JP-A No. 51-37193, JP-B Nos. 2-32293 and 2-16765, or the compounds having the ethylene oxide-based structure as described in JP-B Nos. 58-49860, 56-17654, 62-39417 and 62-39418. Also, the use of the addition-polymerizable compounds having an amino structure or a sulfide structure in the molecule as described in JP-A Nos. 63-277653, 63-260909 and 1-105238 can result in a photopolymerizable composition with all excellent photosensitization speed.

Other examples may include polyfunctional acrylates or methacrylates such as the polyester acrylates, the epoxy acrylates resulting from a reaction between an epoxy resin and (meth)acrylic acid, and the like, as respectively described in JP-A No. 48-64183, JP-B Nos. 49-43191 and 52-30490. Mention may be also made of the specified unsaturated compounds as described in JP-B Nos. 46-43946, 1-40337 and 1-40336, and the vinylphosphonic acid-based compounds as described in JP-B No. 2-25493. In some cases, the structure containing a perfluoroalkyl group as described in JP-A No. 61-22048 may be suitably used. Use can be also made of those introduced as photocurable monomers and oligomers in the Journal of the Adhesion Society of Japan, vol.20, No.7, 300-308 (1984).

For these polymerizable compounds, the details of the method of using them such as the compound structure, individual or combined use, the amount of addition and the like may be arbitrarily determined according to the final performance design for the lithographic printing plate precursor. For example, the terms are selected in the following aspects.

In the aspect of strength, a structure having a high content of unsaturation per molecule is preferred, and in most cases, a functionality of two or more is preferred. Also, in order to increase the strength of the image area, namely, the cured film, a functionality of three or more is preferred, and also effective is the method of balancing between the sensitivity and the strength by using compounds with different functionalities or different polymerizable groups (e.g., acrylic esters, methacrylic esters, styrene-based compounds, vinyl ether-based compounds) in a combination.

Further, in the aspect of the compatibility and dispersibility with the other components in the image recording layer (for example, a binder polymer, an initiator, a coloring agent, etc.), too, the selection and the use of polymerizable compounds are important factors, and in certain cases, compatibility can be improved by, for example, the use of low purity compounds or combined use of two or more compounds. It is also possible to select a specific structure, under the purpose of improving the close adherence to the substrate or to the protective layer that will be described below.

The polymerizable compounds are used preferably in a range of from 5 to 80% by weight, and more preferably from 25 to 75% by weight, relative to the total solids content constituting the image recording layer. Further, they may be used alone or in a combination of two or more species. Other aspects in the method of using the addition-polymerizable compounds are such that the structure, blending and the amount of addition can be selected from the viewpoint of the

extent of polymerization inhibition according to oxygen, resolution fogging, change in the refractive index, surface adhesiveness and the like. Moreover, if appropriate, the techniques of layer construction and coating as referred to as undercoating and overcoating may be also carried out.

<Binder polymer (C)>

According to the invention, a binder polymer (C) can be preferably used in order to improve the film strength of the image recording layer or the film-forming property, and to improve the on-press developability. For the binder polymer that is useful in the invention, those conventionally known ones can be used without limitation, and a linear organic polymer having the film-forming property is preferred. Examples of such binder polymer may include acrylic resins, polyvinyl acetal resins, polyurethane resins, polyurea resins, polyimide resins, polyamide resins, epoxy resins, methacrylic resins, polystyrene resins, phenolic resins of the novolac type, polyester resins, a synthetic rubber and a natural rubber.

In the case of carrying out the development treatment in alkali, those containing an acid group such as a carboxyl group, a sulfone group, a phosphate group and the like are preferred, while in the case of carrying out the on-press development or the development treatment in non-alkali, those containing no acid group are preferred.

The binder polymer preferably has crosslinkability in order to improve the film strength is the image area. In order to impart crosslinkability to the binder polymer, it is preferable to introduce a crosslinkable functional group such as an ethylenic unsaturated bond into the backbone or the side chain of the polymer. The crosslinkable functional group may be also introduced via copolymerization.

Examples of the polymer having ethylenic unsaturated bonds in the backbone of the molecule may include poly-1,4-butadiene, poly-1,4-isoprene and the like.

Examples of the polymer having ethylenic unsaturated bonds in the side chain of the molecule are polymeric esters or amides of acrylic acid or methacrylic acid, and the polymers having ethylenic unsaturated bonds in the ester or amide residue (R in -COOR or -CONHR) may be included.

As examples of the residue (R in the above) having ethylenic unsaturated bonds, mention may be made of $-(CH_2)nCR1=CR2R3$, $-(CH_2O)nCH_2CR1=CR2R3$, $-(CH_2CH_2O)nCH_2CR1=CR2R3$, $-(CH_2)nNH-CO-O-CH_2CR1=CR2R3$, $-(CH_2)n-O-CO-CR1=CR2R3$ and $-(CH_2CH_2O)_2-X$, wherein R1 to R3 each represent a hydrogen atom, a halogen atom or an alkyl group, an aryl group, an alkoxy group or an aryloxy group respectively having 1 to 20 carbon atoms, and R1 and R2 or R3 may be joined together to form a ring; n represents an integer between 1 and 10; and X represents a dicyclopentadienyl residue.

Specific examples of the ester residue may include $-CH_2CH=CH_2$ (described in the publication of JP-B No. 7-21633), $-CE_2CH_2O-CH_2CH=CH_2$, $-CH_2C(CH_3)=CH_2$, $-CH_2CH=CH_6H_5$, $-CH_2CH_2OCOCH=CH-C_6H_5$, $-CH_2CH_2-NH-COO-CH_2CH=CH_2$ and $-CH_2CH_2O-X$, wherein X represents a dicyclopentadienyl residue.

Specific examples of the amide residue may include $-CH_2CH=CH_2$, $-CH_2CH_2-Y$, where Y represents a a cyclohexene residue, and $-CH_2CH_2-OCO-CH=CH_2$.

Concerning the crosslinkable binder polymer, a free radical (the polymerization-initiating radical or the growing radical in the course of polymerization of the polymeric compound) is added to the crosslinkable functional group, addition polymerization is effected directly between polymers or via the polymerization chains of the polymeric compounds, and thereby crosslinking is achieved between polymeric molecules to finally cure the system. Alternatively, an atom in the polymer (for example, a hydrogen atom on a carbon atom adjacent to the functional crosslinking group) is removed by a free radical, subsequently polymeric radicals are generated and joined together, and thereby crosslinking is achieved between polymeric molecules to finally cure the system.

The content of the crosslinkable group in the binder polymer (the content of the radical-polymerizable, unsaturated double bond as measured by iodine titration) is preferably from 0.1 to 10.0 mmol, more preferably from 1.0 to 7.0 mmol, and most preferably from 2.0 to 5.5 mmol, relative to 1 g of the binder polymer. Within these ranges, good sensitivity and good stability on storage are obtained.

Further, from the viewpoint of an unexposed area on the image recording layer capable of the on-press development, the binder polymer preferably has high solubility or dispersibility in ink and/or fountain solution.

In order to improve the solubility or dispersibility in ink, the binder polymer is preferably oleophilic, whereas in order to improve the solubility or dispersibility in fountain solution, the binder polymer is preferably hydrophilic. For this reason, it is effective for the invention to use a combination of an oleophilic binder polymer and a hydrophilic binder polymer

As a hydrophilic binder polymer, mention maybe favorably made of, for example, those having a hydrophilic group such as a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group, a phosphoric acid group and the like.

Specific examples may include gum arable, casein, gelatin, starch derivatives, carboxymethyl cellulose and its sodium salt, cellulose acetate, sodium alginate, vinyl acetate-maleic acid copolymers, styrene-maleic acid copolymers,

polyacrylic acids and their salts, polymelhacrylic acids and their salts, homopolymers and copolymers of hydroxyethyl methacrylate, homopolymers and copolymers of hydroxyethyl acrylate, homopolymers and copolymers of hydroxypropyl methacrylate, homopolymers and copolymers of hydroxypropyl acrylate, homopolymers and copolymers of hydroxybutyl methacrylate, homopolymers and copolymers of hydroxybutyl acrylate, polyethylene glycols, hydroxypropylene polymers, polyvinyl alcohols, hydrolyzed polyvinyl acetate having a degree of hydrolysis of 60 mol% or more, and preferably 80 mol% or more, polyvinyl formal, polyvinyl butyral, polyvinyl pyrrolidone, homopolymers and copolymers of acrylamide, homopolymers and copolymers of methacrylamide, homopolymers and copolymers of N-methylol acrylamide, polyvinyl pyrrolidone, alcohol-soluble nylon, polyether of 2,2-bis-(4-hydroxyphenyl)-propane and of epichlorohydrin, and the like.

The binder polymer preferably has a weight-average molecular weight of 5,000 or more, and more preferably of from 10,000 to 300,000, and has a number-average molecular weight of 1,000 or more, and more preferably of from 2,000 to 250,000. The polydispersity (weight-average molecular weight/number-average molecular weight) is preferably from 1.1 to 10.

The binder polymer is preferably any one of a random polymer, a block polymer and a graft polymer, a random polymer being more preferred.

The binder polymer can be synthesized by the methods known in prior art. As the solvent used for the synthesis, for example, tetrahydrofuran, ethylene dichloride, cyclohexanone, methyl ethyl ketone, acetone, methanol, ethanol, ethylene glycol monomethyl ether, ethylene glycol monoethyl ether, 2-methoxyethyl acetate, diethylene glycol dimethyl ether, 1-methoxy-2-propanol, 1-methoxy-2-propyl acetate, N,N-dimethyl formamide, N,N-dimethyl acetamide, toluene, ethyl acetate, methyl lactate, ethyl lactate, dimethyl sulfoxide and water may be mentioned. These are used alone or in a mixture of two or more species.

As the radical polymerization initiator used for the synthesis of the binder polymer, known compounds such as azo-based initiators, peroxide initiators and the like may be used.

The binder polymer may be used alone or in a mixture of two or more species.

The content of the binder polymer is preferably from 10 to 90% by weight, more preferably from 20 to 80% by weight, and even more preferably from 30 to 70% by weight, relative to the total solids content of the image recording layer. Within these ranges, it is possible to obtain good strength in the image area and good image formability.

Further, it is preferable to use the polymerizable compound (B) and the binder polymer in such amounts that are at a mass proportion of from 1/9 to 7/3.

<Other components for the image recording layer>

The image recording layer of the invention may contain additives such as a surfactant, a coloring agent, an image printing aid, a polymerization inhibitor, a higher fatty acid derivative, a plasticizer, inorganic microparticles, a low-molecular-weight hydrophilic compound and the like, if necessary. Hereinafter, explanation will be given on these components.

<Surfactant>

According to the invention, surfactants are preferably used in the image recording layer in order to promote the on-press developability at the initiation of printing and to improve the state of the film surface. For such surfactants, nonionic surfactants, anionic surfactants, cationic surfactants, amphoteric surfactants, fluorine-based surfactants and the like may be mentioned. The surfactants may be used alone or in a combination of two or more species.

The nonionic surfactants used in the invention are not particularly limited, and those known in prior an can be used. For example, mention may be made of polyoxyethylene alkyl ethers, polyoxyethylene alkyl phenyl ethers, polyoxyethylene polystyryl phenyl ethers, polyoxyehtylene polyoxypropylene alkyl ethers, glycerin fatty acid partial esters, sorbitan fatty acid partial esters, pentaerythritol fatty acid partial esters, propylene glycol monofatty acid esters, sucrose and fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylenated castor oils, polyoxyethylene glycerin fatty acid partial esters, fatty acid diethanol amides, N,N-bis-2-hydroxyalkylamines, polyoxyethylene alkylamine, triethanolamine fatty acid esters, trialkylamine oxides, polyethylene glycol, and copolymers of polyethylene glycol and polypropylene glycol.

The anionic surfactants used in the invention are not particularly limited, and those known in prior art can be used. For example, mention may be made of fatty acid salts, abietates, hydroxyalkane sulfonates, alkane sulfonates, dialkylsulfosuccinic ester salts, straight-chained alkylbenzene sulfonates, branched alkylbenzene sulfonates, alkylnaphthalene sulfonates, alkylphenoxy polyoxyethylene propylsulfonates, polyoxyethylene alkylsulfophenyl ether salts, sodium N-methyl-N-oleyltaurate, disodium N-alkylsulfosuccinic acid monoamide, petroleum sulfonates, beef tallow sulfate, sulfuric acid ester salts of fatty acid alkyl esters, alkyl sulfuric acid ester salts, polyoxyethylene alkyl ether sulfuric acid ester salts, fatty acid monoglyceride sulfuric acid ester salts, polyoxyethylene alkylphenyl ether sulfuric acid ester salts, polyoxyethylene styrylphenyl ether sulfuric acid ester salts, alkyl phosphoric acid ester salts, polyoxyethylene alkyl ether phosphoric acid ester salts, polyoxyethylene alkyl phenyl ether phosphoric acid ester salts, partial saponification products of styrene/maleic anhydride copolymers, partial saponification products of olefin/maleic anhydride copolymers, and naphthalene sulfonate formalin condensates.

The cationic surfactants used in the invention are not particularly limited, and those known in prior art can be used. For example, mention may be made of alkylamine salts, quaternary ammonium salts, polyoxyethylene alkylamine salts, and polyethylene polyamine derivatives.

The amphoteric surfactants used in the invention are not particularly limited, and those known in prior art can be used. For example, carboxybetaines, aminocarboxylic acids, sulfobetaines, aminosulfuric acid esters and imidazolines may be mentioned.

In addition, among the above-described surfactants, those involving "polyoxyethylene" may be also read as "polyoxyalkylene" such as polyoxymethylene, polyoxypropylene, polyoxybutylene and the like, and the invention can also make use of those surfactants.

For more preferable surfactants, fluorine-based surfactants containing a perfluoroalkyl group in the molecule may be mentioned. Such fluorine-based surfactants may include, for example, the anionic type such as perfluoroalkyl carboxylates, perfluoroalkyl sulfonates, perfluoroalkyl phosphoric acid esters and the like; the amphoteric type such as perfluoroalkyl betaine and the like, the cationic type such as perfluoroalkyl trimethyl ammonium salts and the like; the nonionic type such as perfluoroalkylamine oxides, perfluoroalkyl ethylene oxide adducts, oligomers containing perfluoroalkyl group and hydrophilic group, oligomers containing perfluoroalkyl group and lipophilic group, oligomers containing perfluoroalkyl group, hydrophilic group and lipophilic group, urethanes containing perfluoroalkyl group and lipophilic group, and the like. Further, the fluorine-based surfactants as described in the publications of JP-A Nos. 62-170950, 62-226143 and 60-168144 are also preferred.

Surfactants can be used alone or in a combination of two or more species.

The content of surfactants is preferably from 0.001 to 10% by weight, and more preferably from 0.01 to 7% by weight, relative to the total solids content of the image recording layer.

<Coloring agent>

According to the invention, a variety of compounds other than the above compounds may be added, if necessary. For example, a dye exhibiting large absorption in the visible region can be used as the image coloring agent. Specifically, Oil Yellow #101, Oil Yellow #103, Oil Pink #312, Oil Green BG, Oil Blue BOS, Oil Blue #603, Oil Black BY, Oil Black BS, and Oil Black T-505 (all manufactured by Orient Chemical Industries Ltd.); Victoria Pure Blue, Crystal Violet (CI42555), Methyl Violet (CI42535), Ethyl Violet, Rhodamine B (CI145170B), Malachite Green (CI42000), and Methylene Blue (CI52015), and the like; and dyes described in JP-A No. 62-293247. Pigments such as phthalocyanine-based pigments, azo-type pigments, carbon black and titanium oxide and the like may be suitably used.

These coloring agents are preferably added because the agents are useful to easily distinguish between image areas and non-image areas after images are formed. The amount of addition thereof is preferably from 0.01 to 10% by weight relative to the total solids content of the image recording material.

<Image printing aid>

Compounds that undergo discoloration by acid or radical can be added to the image recording layer of the invention for formation of print out images. As such compounds, various dyes, for example, diphenylmethane, triphenylmethane, thiazine, oxazine, xanthene, anthraquinone, iminoquinone, azo and azomethine dyes, and the like are effectively used.

Specific examples thereof may include Brilliant Green, Ethyl Violet, Methyl Green, Crystal Violet, Basic Fuchsine, Methyl Violet 2B, Quinaldine Red, Rose Bengal, Metanil Yellow, Thymolsulfophthalein, Xylenol Blue, Methyl Orange, Paramethyl Red, Congo Red, Benzopurpurine 4B, α-Naphthyl Red, Nile Blue 2B, Nile Blue A, Methyl Violet, Malachite Green, Parafuchsine, Victoria Pure Blue BOH (manufactured by HODOGAYA CHEMICAL Co., Ltd.), Oil Blue #603 (manufactured by Orient Chemical Industry Co., Ltd.), Oil Pink #312 (manufactured by Orient Chemical Industry Co., Ltd.), Oil Red 5B (manufactured by Orient Chemical Industry Co., Ltd.), Oil Scarlet #308 (manufactured by Orient Chemical Industry Co., Ltd.), Oil Red OG (manufactured by Orient Chemical Industry Co., Ltd.), Oil Red RR (manufactured by Orient Chemical Industry Co., Ltd.), Oil Green #502 (manufactured by Orient Chemical Industry Co., Ltd.), Spiron Red BEH Special (manufactured by HODOGAYA CHEMICAL Co., Ltd.), m-Cresol Purple, Cresol Red, Rhodamine B, Rhodamine 6G, Sulforhodamine B, Auramine, 4-p-diethylaminophenylinminonaphthoquinone, 2-carboxyanilino-4-p-diethylaminophenyliminoaphthoquinone, 2-carboxystearylamino-4-p-N,N-bis(hydroxyethyl)amino-phenyliminonaphthoquinone, 1-phenyl-3-methyl-4-p-diethylaminophenylimino-5-pyrazolone, 1-β-naphthyl-4-p-diethylaminophenylimino-5-pyrazolone and the like, and leuco dyes such as p,p',p"-hexamethyltriaminotriphenylmethane (Leuco Crystal Violet),

Pergascript Blue SRB (manufactured by Ciga Geigy A.G.) and the like.

In addition to the above, leuco dyes known as the materials of heat-sensitive paper and pressure-sensitive paper can be also mentioned to be very suitable. Specific examples thereof include Crystal Violet Lactone, Malachite Green Lactone, Benzoyl Leuco Methylene Blue, 2-(N-phenyl-N-methylamino-6-(N-p-tolyl-N-ethyl)amino-fluoran, 2-anilino-3-methyl-6-(N-ethyl-p-toluidino)-fluoran, 3,6-dimethoxyfluoran, 3-(N,N-diethylamino)-5-methyl-7-(N,N-dibenzylamino)fluoran, 3-(N-cyclohexyl-N-methylamino)-6-methyl-7-anilinofluoran, 3-(N,N-diethylamino)-6-methyl-7-anilinofluoran, 3-(N,N-diethylamino)-6-methyl-7-xylidinofluoran, 3-(N,N-diethylamino)-6-methyl-7-chlorofluoran, 3-(N,N-diethylamino)-6-methoxy-7-aminofluoran, 3-(N,N-diethylamino)-7-(4-chloroanilino)fluoran, 3-(N,N-diethylamino)-7-chlorofluoran, 3-(N,N-diethylamino)-7-benzylaminofluoran, 3-(N,N-diethylamino)-7,8-benzofluoran, 3-(N,N-dibutylamino)-6-methyl-7-anilinofluoran, 3-(N,N-dibutylamino)-6-methyl-7-xylidinofluoran, 3-piperidino-6-methyl-7-anilinofluoran, 3-pyrrolidino-6-methyl-7-anilinofluoran, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-phthalide, 3-(4-diethylaminophenyl)-3-(1-ethyl-2-methylindol-3-yl)phthalide and the like.

The amount of addition for the dyes that undergo discoloration by acid or radical is from 0.01 to 15% by weight respectively, relative to the solids content of the image recording layer.

<Polymerization inhibitor>

A small amount of thermal polymerization inhibitor is preferably added to the image recording layer of the invention, in order to prevent unnecessary thermal polymerization of the radical-polymerizable compound during the preparation or storage of the image recording layer.

Examples of such thermal polymerization inhibitor may be mentioned favorably of hydroquinone, p-methoxyphenol, di-t-butyl-p-cresol, pyrogallol, t-butylcatechol, benzoquinone, 4,4'-thiobis(3-methyl-6-t-bulylphenol), 2,2'-methylenebis(4-methyl-6-t-butylphenol), and the aluminum salt of N-nitroso-N-phenylhydroxylamine.

The amount of the thermal polymerization inhibitor to be added is preferably from about 0.01% to about 5% by weight relative to the total solids content of the image recording layer.

<Higber fatty acid derivatives, etc.>

In the image recording layer of the invention, higher fatty acid derivatives and the like such as behenic acid or behenic acid amide and the like may be added and localized at the surface of the image recording layer in the process of drying after coating, in order to prevent the polymerization hindrance due to oxygen. The amount of higher fatty acid derivatives to be added is preferably from about 0.1 to about 10% by weight relative to the total solids content of the image recording layer.

<Plasticizer>

The image recording layer of the invention may contain plasticizers in order to improve the on-press developability.

As such plasticizer, mention may be made preferably of, for example, phthalic acid esters such as dimethyl phthalate, diethyl phthalate, dibutyl phthalate, diisobutyl phthalate, dioctyl phthalate, octylcapryl phthalate, dicyclohexyl phthalate, ditridecyl phthalate, butylbenzyl phthalate, diisodecyl phthatlate, diaryl phthalate and the like; glycolic esters such as dimethyl glycol phthalate, ethylphthalylethyl glycolate, methylphthalylethyl glycolate, butylphthalylbutyl glycolate, triethylene glycol dicaprilic acid ester and the like; phosphoric acid esters such as tricresyl phosphate, triphenyl phosphate and the like, aliphatic dibasic acid esters such as diisobutyl adipate, dioctyl adipate, dimethyl sebacate, dibutyl sebacate, dioctyl azelate, dibutyl maleate and the like; polyglycidyl methacrylate, triethyl citrate, glycerin triacetyl ester, butyl laurate and the like.

The content of the plasticizer is preferably about 30% by weight or less relative to the total solids content of the image recording layer.

<Inorganic microparticles>

The image recording layer of the invention may contain inorganic microparticles for the improvement of the cured film strength at the image area and the improvement of the on-press developability at the non-image area.

As such inorganic microparticles, mention may be made preferably of, for example, silica, alumina, magnesium oxide, titanium oxide, magnesium carbonate, calcium alginate or mixtures thereof. Even though they may not be photo/thermo-modifiable, the microparticles can be used for strengthening of the film, intensification of the interface-adherence by means of surface-roughening, and the like.

Inorganic microparticles have an average particle diameter of preferably from 5 nm to 10 μm, and more preferably from 0.5 to 3 μm. In these ranges, they can be stably dispersed within the image recording layer to sufficiently maintain the film strength of the image recording layer, and can form a non-image area which has excellent hydrophilicity, thus making the area difficult to be contaminated upon pointing.
Such inorganic microparticles as described in the above are easily available as commercial products such as colloidal silica dispersions and the like.
The content of the inorganic microparticles is preferably 20% by weight or less, and more preferably 10% by weight or less, relative to the total solids content of the image recording layer.

<Low molecular weight hydrophilic compound>

The image recording layer of the invention may contain hydrophilic low molecular weight compounds for improving the on-press developability. Examples of the hydrophilic low molecular weight compound may be mentioned of, as the water-sohrble organic compound, glycols such as ethylene glycol, diethylene glycol, triethylene glycol, propylene glycol, dipropylene glycol, tripropylene glycol and the like and ether or ester derivatives thereof, polyhydroxies such as glycerin, pentaerythritol and the like; organic amines such as triethanolamine, diethanolamine, monoethanolamine and the like and salts thereof; organic sulfonates such as toluene sulfonate, benzene sulfonate and the like and salts thereof; organic phosphonates such as phenyl phosphonate and the like and salts thereof, and organic carboxylic acids such as tartaric acid, oxalic acid, citric acid, malic acid, lactic acid, gluconic acid, amino acids and the like and salts thereof.

<Formation of the image recording layer>

According to the invention, several embodiment can be used as the method of incorporating the above-mentioned constituents of the image recording layer into the image recording layer. One embodiment, for example, is an image recording layer of the molecular dispersion type prepared by dissolving the constituents in a suitable solvent and applying the solution, as described in the publication of JP-A No. 2002-287334. Another embodiment, for example, is an image recording layer of the microcapsule type prepared by incorporating all or part of the above-mentioned constituents in the state of being microencapsulated, as described in publications of JP-A Nos. 2001-277740 and 2001-277742. In the microcapsule type image recording layer, a part of the component to be contained can be encapsulated inside the microcapsules, and the remaining can be contained outside the microcapsules in the image recording layer at an arbitrary ratio. Here, the microcapsule type image recording layer is preferably in the state of containing the hydrophobic constituents inside the microcapsules and the hydrophilic constituents outside the microcapsules. In order to obtain better on-press developability, the image recording layer is preferably the microcapsule type image recording layer.
As the method of microencapsulating the aforementioned constituents of the image recording layer, any known method can be employed. For example, as the method of preparing microcapsules, the method of utilizing coacervation as described in the specifications of USP Nos. 2800457 and 2800458; the interfacial polymerization method as described in the specification of USP No. 3287154, and the publications of JP-B Nos. 38-19574 and 42-446; the method of polymer precipitation as described in the specifications of USP Nos. 3418250 and 3660304; the method of using the isocyanate polyol wall material as described in the specification of USP No. 3796669; the method of using the isocyanate wall material as described in the specification of USP No. 3914511; the method of using the wall-forming materials of the urea-formaldehyde system or the urea-formaldehyde-resorcinol system as described respectively in the specifications of U SP Nos. 4001140, 4087376 and 4089802; the method of using the wall materials such as a melamine-formaldehyde resin, hydroxycellulose and the like as described in the specification of USP No. 4025445; the in situ monomer polymerization method as described respectively in the publications of JP-B Nos. 36-9163 and 51-9079; the method of spray-drying as described in the specifications of GBP No. 930422 and USP No. 3111407, the method of electrolytic dispersion cooling as described in the specifications of GBP Nos. 952807 and 967074; and the like may be mentioned, without being limited to these,
**[0175]** The wall of the microcapsules used in the invention preferably has a three-dimensional crosslinked structure and the property of swelling in a solvent. From this point of view, the wall material for the microcapsules is preferably polyurea, polyurethane, polyester, polycarbonate, polyamide and mixtures thereof. Particularly, polyurea and polyurethane is preferred. Also, a compound having a crosslinkable functional group such as ethylenic unsaturated bond and the like which can be introduced to the above-mentioned binder polymer may be introduced to the microcapsule wall.
The average particle diameter of the microcapsule is preferably from 0.01 to 3.0 μm, more preferably from 0.05 to 2.0 μm, and particularly preferably from 0.10 to 1.0 μm. Within these ranges, good resolution and stability over time can be obtained.
The image recording layer of the invention is coated with a coating solution prepared by dispersing or dissolving the respective necessary components in a solvent. For the solvent used herein, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethyl acetamide, N, N-dimethyl formamide, tetramethylurea, N-methylpynolidone, dimethyl sulfoxide, sulfolane, γ-butyl lactone, toluene, water and the like may be mentioned, without being limited to these. These solvents may be used alone or in mixtures. The concentration of the solids in the coating solution is preferably from 1 to 50% by weight.

The image recording layer of the invention can be also formed by preparing a plurality of coating solutions in which the same or different components are dispersed or dissolved in the same or different solvents and repeating the process of applying and drying of the solutions multiple times.

Further, the amount of coating of the image recording laser (the solids content) on the support that can be obtained after coating and drying varies depending on the use, but in general it is preferably from 0.3 to 3.0 g/$m^2$. Within this range, good sensitivity and good film properties of the image recording layer may be obtained.

For the method of coating, various methods can be used. For example, bar-coater coating, rotary coating, spray coating, curtain coating, dip coating, air knife coating, blade coating, roll coating and the like may be mentioned.

<Support>

The support used in the lithographic printing plate precursor in the platemaking method of the invention is not particularly limited, and it may be a dimensionally stable plate-shaped article. For example, mention may be made of paper, paper laminated with plastic (e.g., polyethylene, polypropylene, polystyrene, etc.), metal sheet (e.g., aluminum, zinc, copper, etc.), plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, etc.), paper or plastic film that is laminated or vapor-deposited with the aforementioned metal, and the like. As a preferred support, polyester film and aluminum sheet can be mentioned. Among them, preferred is the aluminum sheet which is dimensionally stable and relatively cost effective.

An aluminum sheet is a pure aluminum sheet or a sheet of an alloy containing aluminum as the main component and trace amounts of other elements. Further, the other elements contained in aluminum alloys are silicon, iron, manganese, copper, magnesium, chromium, zinc, bismuth, nickel, titanium and the like. The content of other elements in an alloy is preferably up to 10% by weight. According to the invention, it is preferred to use a pure aluminum sheet; however, since it is difficult to produce perfectly pure aluminum at the level of the current refinery technology, aluminum sheets may contain small amounts of other elements. The aluminum sheet is not specified of the composition, and those containing materials well known and commonly used can be suitably used.

The thickness of the support is preferably from 0.1 to 0.6 mm, more preferably from 0.15 to 0.4 mm, and even more preferably from 0.2 to 0.3 mm.

Prior to subjecting the aluminum sheet to anodization, it is preferably subjected to surface treatment such as the surface-roughening treatment, the anodizing treatment and the like. Such surface treatment facilitates the improvement of hydrophilicity and assurance of close adherence between the image recording layer and the support. Before surface-roughening the aluminum sheet, if desired, the sheet is subjected to degreasing by surfactants, organic solvents, alkaline aqueous solutions and the like in order to remove the rolling oil remaining on the surface.

The surface-roughening treatment of the aluminum sheet surface may be achieved by various methods, for example, a mechanical surface-roughening treatment, an electrochemical surface-roughening treatment (surface-roughening by dissolving the surface electrochemically), a chemical surface-roughening treatment (snurface-roughening by selectively dissolving the surface chemically) may be mentioned.

As the mechanical surface-roughening method, any known techniques such as ball polishing, brush polishing, blast polishing, buff polishing and the like can be used.

As the electrochemical surface-roughening method, for example, a method of surface-roughening by means of alternating current or direct current in an electrolytic solution containing an acid such as hydrochloric acid, nitric acid and the like may be mentioned. Further, the method of using a mixed acid as described in JP-A No. 54-63902 can be also mentioned.

The surface-roughening treated aluminum sheet is subjected to alkali etching by means of an aqueous solution of potassium hydroxide, an aqueous solution of sodium hydroxide and the like, if necessary. Further, after neutralization, it is anodized for enhancing the abrasion resistance.

For the electrolyte used in the anodization of the aluminum sheet, various electrolytes that form porous oxidized film can be used. In general, sulfuric acid, hydrochloric acid, oxalic acid, chromic acid or mixtures thereof are used. The concentration of such electrolyte is appropriately determined according to the type of electrolyte.

It is difficult to precisely define the conditions for anodization, since the conditions may vary depending on the electrolyte used. However, in general, the following conditions are preferred: concentration of the electrolyte solution: 1 to 80% by weight, liquid temperature: 5 to 70°C, current density: 5 to 60 A/$dm^2$, voltage: 1 to 100 V, and time for electrolysis: 10 sec to 5 min. The amount of thus formed anodized film is preferably from 1.0 to 5.0 g/$m^2$, and more preferably from 1.5 to 4.0 g/$m^2$. Within these ranges, good print durability and good damage resistance at the non-image

area of the lithographic printing plate can be obtained.

The support used in the invention may be used in the form of a substrate per se having a surface-treated anodized film as described above. However, it can be also optionally subjected ta the widening of micropores in the anodized film, sealing of micropores, and surface-hydrophilization by immersing in an aqueous solution containing a hydrophilic substance as described in JP-A Nos. 2001-253181 or 2001-322365, if necessary, in order to further improve the adherence to the upper layer, hydrophilicity, anti-contamination property, insulating property and the like.

For the hydrophilization treatment, mention may be made of alkali metal silicate method as described in the respective specifications of USP Nos. 2,714,066, 3,181,461, 3,280,734 and 3,902,734. In this method, a support is subjected to immersion in an aqueous solution of sodium silicate and the like, or to electrolysis. In addition to this, the method of treating with potassium fluorozirconate as described in the publication of JP-B No. 36-22063, the method of treating with polyvinyl phosphonate as described in the respective specifications of USP Nos. 3,276,868, 4,153,461 and 4,689,272, and the like may be mentioned.

When a support with insufficient surface hydrophilicity such as polyester film and the like is used as the support of the invention, it is preferable to tender hydrophilicity to the surface by coating a hydrophilic layer. For the hydrophilic layer, it is preferred to employ a hydrophilic layer constructed by applying a coating solution containing a colloid of the oxide or hydroxide of at least one element selected from beryllium, magnesium, aluminum, silicon, titanium, arsenic, germanium, tin, zirconium, iron, vanadium, antimony and transition metals as described in the publication of JP-A No. 2001-199175; a hydrophilic layer having an organic hydrophilic matrix that can be obtained by crosslinking or pseudo-crosslinking an organic hydrophilic polymer as described in the publication of JP-A No. 2002-79772; a hydrophilic layer having an inorganic hydrophilic matrix that can be obtained by sol-gel transition consisting of hydrolysis and condensation of polyalkoxysilane, titanate, zirconate can aluminate; or a hydrophilic layer constructed from an inorganic thin film having a surface containing a metal oxide. Among these, preferred is the hydrophilic layer constructed by applying a coating solution containing a colloid of silicon oxide or hydroxide.

Further, when polyester film and the like is used as the support of the invention, it is preferred to furnish the support with an antistatic layer on the side of the hydrophilic layer or the opposite side, or on both sides. When an antistatic layer is provided in between the support and the hydrophilic layer, it also contributes to the improvement of adherence to the hydrophilic layer. As the antistatic layer, use can be made of a polymeric layer and the like in which microparticles of metal oxides or a matting agent is dispersed as described in the publication of TP-A No. 2002-79772.

The support used in the lithographic printing plate precursor in the platemaking method of the invention is preferably a support having on the surface an anodized film with sealed micropores as mentioned below.

The support used in the lithographic printing plate precursor in the image recording method and the lithographic printing method of the invention is a support having on the surface an anodized film with sealed micropores. Specific examples thereof may include metal sheets, paper or plastic film laminated or vapor-deposited with metal, and the like. Preferred support may be exemplified by an aluminum sheet which has good dimensional stability and which is relatively inexpensive.

The aluminum sheet is a pure aluminum sheet or a plate of an alloy containing aluminum as the main component and trace amounts of other elements. The other elements contained in aluminum alloys are silicon, iron, manganese, copper, magnesium, chromium, zinc, bismuth, nickel, titanium and the like. The content of other elements in an alloy is preferably 10% by weight or less. According to the invention, it is preferred to use a pure aluminum sheet; however, since it is difficult to produce perfectly pure aluminum at the level of the current refinery technology, aluminum sheets may contain small amounts of other elements. The aluminum sheet is not specified of the composition, and those containing materials well known and commonly used can be suitably used.

The thickness of the support is preferably from 0.1 to 0.6 mm, more preferably from 0.15 to 0.4 mm, and even more preferably from 0.2 to 0.3 mm.

Prior to subjecting the aluminum sheet to anodization, it is preferably subjected to the surface-roughening treatment. Such surface-roughening treatment facilitates the improvement of hydrophilicity and assurance of close adherence between the image recording layer and the support Before surface-roughening the aluminum sheet, if desired, the plate is subjected to degreasing by surfactants, organic solvents, alkaline aqueous solutions and the like in order to remove the rolling oil remaining on the surface.

The surface-roughening treatment of the aluminum sheet surface may be achieved by various methods, and for example, a mechanical surface-roughening treatment, an electrochemical surface-roughening treatment (surface-roughening by dissolving the surface electrochemically), a chemical surface-roughening treatment (surface-roughening by selectively dissolving the surface chemically) may be mentioned.

As the mechanical surface-roughening method, any known techniques such as ball polishing, brush polishing, blast polishing, buff polishing and the like can be used.

As the electrochemical surface-roughening method, for example, a method of surface-roughening by means of alternating current or direct current in an electrolytic solution containing an acid such as hydrochloric acid, nitric acid and the like may be mentioned. Further, the method of using a mixed acid as described in JP-A No. 54-63902 can be

also mentioned.

The surface-roughening treated aluminum sheet is subjected to alkali etching by means of an aqueous solution of potassium hydroxide, an aqueous solution of sodium hydroxide and the like, if necessary. Further, after neutralization, it is anodized for enhancing the abrasion resistance.

For the electrolyte used in the anodization of the aluminum sheet, various electrolytes that form porous oxidized film can be used. In general, sulfuric acid, hydrochloric acid, oxalic acid, chromic acid or mixtures thereof are used. The concentration of such electrolyte is appropriately determined according to the type of electrolyte.

It is difficult to precisely define the conditions for anodization, since the conditions may vary depending on the electrolyte used. However, in general, the following conditions are preferred: concentration of the electrolyte solution: 1 to 80% by weight, liquid temperature: 5 to 70°C, current density: 5 to 60 A/cm$^2$, voltage: 1 to 100 V, and time for electrolysis: 10 sec to 5 mm. The amount of thus formed anodized film is preferably from 1.0 to 5 .0 g/m$^2$, and more preferably from 1.5 to 4.0 g/m$^2$. Within these ranges, good print durability and good damage resistance at the non-image area of the lithographic printing plate can be obtained.

The support used in the invention is subjected to sealing of the micropores in the anodized film. This sealing can lead to reduction of the specific surface area for the anodized film to a great extent,

The specific surface area of the support used in the invention is preferably 0.5 m$^2$/g or less as measured according to the BET method with respect to the mass of the anodized film provided on the surface of the support. The method for measurement of the specific surface area is as follows.

<Method for measurement of specific surface area>

[Principle of measurement of specific surface area]

When the specific surface area of a porous sample in the form of granulate or powder is measured based on the BET method, it can be calculated from the amount of gas in the monolayer of molecules (so-called monomolecular layer) adsorbed on the sample, and this absorption takes place at or near the boiling point of the adsorbing gas. It is known that under defined conditions, the region of the sample covered by gas molecules is limited to a relatively narrow region, and the specific area of the sample is directly calculated from the number of adsorbed molecules and the area occupied by the molecules that are derived from the amount of gas under the defined conditions. Here, the parameter for the formation of monomolecular layer can be set by data processing according to the multiple-point method.

[Specific measurement procedure]

A support was provided which had been subjected to surface-roughening and anodization, and then optionally subjected to adequate post-treatment, and it was cut to a size fit to be placed inside the measuring cell, thus the specimen for measurement being provided.

The specific surface area was determined using a Micromeritics automatic specific surface area measuring apparatus "Flow Sorb III2305" (manufactured by Shimazu Corporation).

Initially, the specimen cell was heated to 250°C for 90 minutes to carry out the degassing operation in which any gas generated from the specimen surface or the moisture absorbed from the atmosphere is removed. Then, the specimen was weighed, the specimen cell was maintained in liquefied nitrogen, and the amount of absorption was determined by introducing a gas consisting of 99.9% of helium and 0.1% of Krypton to the cell. After equilibrium was reached, the cell was returned to below room temperature, and the amount of desorption was measured. Thus, the specific surface area was calculated based on the measured amount of adsorption, the amount of desorption and the mass of specimen.

"Method of measuring the mass anodized film on the substrate"

The amount of anodized film on the substrate was determined in the following manner.

In a solution commonly called as Mason's solution which can be obtained by weighing and mixing 30 g of chromium (IV) oxide-chromic anhydride, 118 g of 85% by weight of phosphoric acid and 1500 g of pure water, the substrate was immersed for 12 hours to dissolve only the anodized film. From the mass change, the amount of anodized film (mass) per unit area was determined.

The specific surface area that can be obtained according to the BET method is calculated with respect to the total mass of the support, which is the specimen to be measured. The value obtained by abstracting the value of the surface area obtainable therefrom (the value prior to removal of the specimen mass) from the mass of the anodized firm corresponding to the specimen surface area used in the measurement, was taken as the "specific surface area measured according to the BET method with respect to the mass of anodized film provided on the surface."

Further, the reliability of the measured value obtainable from every measurement was assured by calibration of the specific surface area using commercially available alumina and silica microparticles of known specific surface area (Admatechs AO-502, SO-CI).

The sealing treatment used in the invention is not particularly limited, and conventionally known methods can be used. Among those, preferred are the scaling treatment by means of an aqueous solution containing an inorganic fluorine compound, the sealing treatment by means of steam and the sealing treatment by means of hot water. An explanation will be given below on each of them.

<Sealing treatment by means of an aqueous solution containing an inorganic fluorine compound>

As the inorganic fluorine compound used in the sealing treatment by means of an aqueous solution containing an inorganic fluorine compound, metal fluorides can be mentioned to be very suitable.

Specifically, mention may be made of, for example, sodium fluoride, potassium fluoride, calcium fluoride, magnesium fluoride, sodium fluorozirconate, potassium fluorozirconate, sodium fluorotitanate, potassium fluorotitanate, ammonium fluorozirconate, ammonium fluorotitanate, potassium fluorotitanate, fluorozirconic acid, fluorotitanic acid, hexafluorosilic acid, nickel fluoride, iron fluoride, fluorophosphoric acid and ammonium fluorophosphates. Of these, sodium fluorozirconate, sodium fluorotitanate, fluorozirconic acid and fluorotitanic acid are preferred.

The concentration of the inorganic fluorine compound in the aqueous solution is preferably 0.01% by weight or more, and more preferably 0.05% by weight or more, from the perspective of sufficiently carrying out the sealing of micropores in the anodized film. Further, from viewpoint of anti-contamination property, the concentration is preferably 1% by weight or less, and more preferably 0.5% by weight or less.

The aqueous solution containing an inorganic fluorine compound preferably further contains a phosphate compound. With a phosphate compound contained, the hydrophilicity at the surface of the anodized film is improved, and thus the on-press developability and anti-contamination property are improved.

The phosphate compound may be exemplified suitably by the phosphates of metals such as alkali metals, alkali earth metals and the line.

Specifically, mention may be made of, for example, zinc phosphate, aluminum phosphate, ammonium phosphate, diammonium hydrogen phosphate, ammonium dihydrogen phosphate, ammonium phosphate, potassium phosphate, sodium phosphate, potassium dihydrogen phosphate, dipotassium hydrogen phosphate, calcium phosphate, sodium ammonium hydrogen phosphate, magnesium hydrogen phosphate, magnesium phosphate, ferrous phosphate, ferric phosphate, sodium dihydrogen phosphate, sodium phosphate, disodium hydrogen phosphate, lead phosphate, diammonium phosphate, calcium dihydrogen phosphate, lithium phosphate, phosphotungstic acid, ammonium phosphotungstate, sodium phosphotungstate, ammonium phosphomolibdate, sodium phosphomolibdate, sodium phosphite, sodium tripolyphosphate and sodium pyrrolinate. Among these, sodium dihydrogen phosphate, disodium hydrogen phosphate, potassium dihydrogen phosphate and dipotassium hydrogen phosphate are preferred.

The combination of an inorganic fluorine compound and a phosphate compound is not particularly limited, but an aqueous solution containing at least sodium fluorozirconate as the inorganic fluorine compound and containing at least sodium dihydrogen phosphate as the phosphate compound is preferred.

The concentration of the phosphate compound in the aqueous solution is preferably 0.01% by weight or more, and more preferably 0.1% by weight or more, from the viewpoint of improvement of the on-press developability and anti-contammntion property, and it is preferably 20% by weight or less, and more preferably 5% by weight or less, from the viewpoint of solubility.

The ratio of the respective compounds of the aqueous solution is not particularly limited, but the mass ratio of the inorganic fluorine compound and the phosphate compound is preferably from 1/200 to 10/1, and more preferably from 1/30 to 2/1.

Further, the temperature of the aqueous solution is preferably 20°C or more, and more preferably 40°C or more. It is also preferably 100°C or less, and more preferably 80°C or less.

The pH value of the aqueous solution is preferably 1 or more, and more preferably 2 or more. It is also preferably 11 or less, and more preferably 5 or less.

The method for sealing treatment by means of an aqueous solution containing an inorganic fluorine compound is not particularly limited, and for example, the immersion method and the spray method may be mentioned. These methods may be used once only or in several times, and may be also used in a combination of two or more species.

Among them, the immersion method is preferred. When treatment is carried out by the immersion method, the time for treatment is preferably 1 second or more, and more preferably 3 seconds or more. It is also preferably 100 seconds or less, and more preferably 20 seconds or less.

<Sealing treatment by means of steam>

For the sealing treatment by means of steam, mention may be made of, for example, the method of contacting the anodized film with steam at an elevated pressure or ambient pressure continuously or discontinuously.
The temperature of the steam is preferably 80°C or more, and more preferably 95°C or more. It is also preferably 105°C or lass.
The pressure of steam is preferably in a range of from (atmospheric pressure - 50 mmAq) to (atmospheric pressure + 300 mmAq) ($1.008 \times 10^5$ - $1.043 \times 10^5$ Pa).
Also, the time for contacting with steam is preferably 1 second or more, and more preferably 3 seconds or more. It is also preferably 100 seconds or less, and more preferably 20 seconds or less.

<Sealing treatment by means of hot water>

For the sealing treatment by means of hot water, mention may be made of, for example, the method of immersing aluminum sheet, which formed anodized film, in hot water.
Hot water may contain an inorganic salt (e.g., phosphate) or an organic salt.
The temperature of hot water is preferably 80°C or more, and more preferably 95°C or more. It is also preferably 100°C or less.
Further, the time for immersing in hot water is preferably 1 second or more, and more preferably 3 seconds or more. It is also preferably 100 seconds or less, and more preferably 20 seconds or less.
According to the invention prior to the sealing treatment, the treatment of enlarging micropores in the anodized film as described in the publication of JP-A No. 2001-322365 can be carried out. Further, after sealing, the treatment of surface hydrophilization can be also carried out.
For the hydrophilization treatment, mention may be made of the alkali metal silicate method as described in the respective specifications of USP Nos. 2,714,066, 3,181,461, 3,280,734 and 3,902,734. In this method, a support is subjected to immersion in an aqueous solution of sodium silicate and the like, or to electrolysis. In addition to this, the method of treating with potassium fluorozirconate as described in the publication of JP-B No. 36-22063, the method of treating with polyvinyl phosphonate as described in the respective specifications of USP Nos. 3,276,868, 4,153,461 and 4,689,272, and the like may be mentioned.
The support of the invention preferably has a centerline average roughness of from 0.10 to 1.2 μm. Within this range, good adherence to the image recording layer, good print durability and good anti-contamination property can be obtained.
Also, the color density of the support is preferably from 0.15 to 0.65 as the value of reflective density. Within this range, good image formability due to prevention of halation upon imagewise exposure and good visibility after development can be obtained.

<Undereoat layer>

It is preferable to provide an undercoat layer of a compound containing a polymerizable group on the support of the lithographic printing plate precursor of the invention. When the undercoat layer is used, the image recording layer is furnished above the undercoat layer. The undercoat layer enhances the adherence between the support and the image recording layer at the exposed area, and it improves the on-press developability at the unexposed area because it facilitates delamination of the image recording g layer from the support.
For the undercoat layer, specifically, the silane coupling agent having an ethylenically double-bonded reactive group capable of undergoing addition polymerization as described in JP-A No. 10-282679, the phosphorus compound having an ethylenically double-bonded reactive group as described in JP-A No. 2-304441, and the like can be mentioned favorably. Also preferred is a compound having a polymerizable group such as a methacryl group, an aryl group and the like, and a support-adherent group such as a sulfonic acid group, a phosphoric acid group, a phosphoric acid ester and the like. Furthermore, a compound having a hydrophilicity-imparting group such as an ethyleneoxy group and the like added to the above compound is also very suitable.
The amount of coating (solids content) of the undercoat layer is preferably from 0.1 to 100 $mg/m^2$, and more preferably from 1 to 30 $mg/m^2$.

<Backcoat layer>

After implementation of the surface treatment or formation of an undercoat layer on the support, a backcoat can be furnished on the opposite side of the support, if necessary.
As such backcoat, mention may be made favorably of, for example, the coating layer consisting of a metal

oxide which can be obtained by hydrolysis and polycondensation of an organic polymeric compound as described in JP-A No. 5-45885, or an organic metal compound or an inorganic metal compound as described in JP-A No. 6-35174. Among these, it is preferable to use an alkoxy compound of silicon such as $Si(OCH_3)_4$, $Si(OC_2H_5)_4$, $Si(OC_3H_7)_4$, $Si(OC_4H_9)_4$ and the like, from the viewpoint of the availability of the raw materials at low costs.

<Protective layer>

Since the formation of image by exposure is not likely to be affected by oxygen in the lithographic printing plate precursor of the invention that is used according to the lithographic printing method of the invention, a protective layer under the purpose of blocking oxygen is not necessarily required. However, a protective layer can be furnished above the image recording layer in order to prevent any occurrence of damage and the like in the image recording layer, to prevent abrasion during exposure to a high illumination intensity laser, or to block oxygen to further increase the image strength, if necessary.

According to the invention, exposure to light is typically carried out in the atmosphere. The protective layer prevents incorporation into the image recording layer, of a low molecular weight compound present in the atmosphere, which inhibits the image-forming reaction occurring in the image recording layer upon exposure, such as oxygen, basic substances and the like, and thus the layer prevents inhibition of the image-forming reaction occurring in the atmosphere upon light exposure. Therefore, the properties required from the protective layer are preferably low permeability to a low molecular weight compound such as oxygen and the like, good permeability to the light used in exposure, excellent adherence to the image recording layer, and good removability during the process of the on-press development after exposure. Investigation on such a protective layer having the above-mentioned properties has been carried out extensively, and such protective layers are described in detail, for example, in USP No. 3,458,311 and JP-B No. 55-49729.

The material used for the protective layer may be exemplified by water-soluble polymeric compounds having relatively high crystallinity. Specifically, mention may be made of water-soluble polymers such as polyvinyl alcohol, polyvinyl pyrrolidone, acidic celluloses, gelatin, gum arabic, polyacrylic acid and the like.

When polyvinyl alcohol (PVA) among them is used as the main component, the best results can be obtained with respect to the fundamental properties such as oxygen blocking, removability of the developed image and the like, Polyvinyl alcohol may be partially substituted by esters, ethers or acetals, or may partially contain other copolymerizable components, as long as the polymer contains the unsubstiuted vinyl alcohol unit which provides the ability of blocking oxygen and water-solubility required in the protective layer.

Specific examples of polyvinyl alcohol may be preferably those having a degree of polymerization in a range of from 300 to 2400 and a degree of hydrolysis in a range of from 71 to 100 mol%. Mention may be made specifically of, for example, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, all manufactured by Kuraray Co., Lid.

The component of the protective layer (selection of PVA, use of additives, etc.), the amount of coating and the like may be appropriately selected in consideration of the properties such as fogging, close adherence, resistance to damage and the like, in addition to the ability of blocking oxygen and removability af the developed image. In general, as the degree of hydrolysis of PVA increases (i.e., as the content of the unsubstituted vinyl alcohol unit in the protective layer is higher), and as the film thickness increase, the ability of blocking oxygen also increases, and this is preferable in the aspect of sensitivity. Also, it is preferable not to have excessively high oxygen permeability, in order to prevent unnecessary polymerization reactions during production and storage, unnecessary fogging during exposure of the image, and thickening of the image lines. Thus, the oxygen permeability A is preferably such that $0.2 \le A \le 20$ (cc/m$^2$(day) at 25°C and 1 atmosphere.

As other constituents of the protective layer, glycerin, dipropylene glycol and the like may be added in an amount equivalent to several percent by weight with respect to the (co)polymer in order to impart flexibility, and anionic surfactants such as sodium alkyl sulfate, sodium alkyl sulfonate and the like; cationic surfactants such as alkylaminocarboxylates, alkylaminodicarboxylates and the like, and nonionic surfactants such as polyoxyethylene alkylphenyl ether and the like may be also added in an amount of several percent by weight with respect to the (co)polymer.

In addition, the close adherence to the image area of the protective layer, resistance to damage and the like are also very important in terms of the handlability of the lithographic printing plate precursor. That is, when the hydrophilic protective layer is laminated on the oleophilic image recording layer in order to have water-soluble compounds contained therein, delamination of the protective layer due to insufficient adhesive force is susceptible to occur, and there is a risk of suffering from defects such as poor film curing and the like, which in turn causes suppression of polymerization by oxygen at the delaminated area.

In this regard, there have been a variety of suggestions to improve adherence between the image recording layer and the protective layer. For example, it is described in JP-A No. 49-70702 and GB-A No. 1303578 that sufficient adherence can be achieved by mixing in a hydrophilic polymer mainly consisting of polyvinyl alcohol, an acrylic emulsion,

a water-insoluble vinyl pyrrolidone-vinyl acetate copolymer and the like in a portion of from 20 to 60% by weight, and laminating the mixture on the image recording layer. All of these known techniques can be used in the invention.

Moreover, other functions can be also imparted to the protective layer. For example, the aptitude to safelight can be improved without lowering of the sensitivity, by adding a coloring agent (e.g., a water-soluble dye) which is excellent in the permeability to the infrared ray used in light exposure, and which can absorb efficiently the light of a wavelength other than the foregoing.

The film thickness of the protective layer is suitably from 0.1 to 5 μm, and particularly suitably from 0.2 to 2 μm.

The methods of coating a protective layer are described in detail in, for example, USP No. 3,458,311 and JP-B No. 55-49729.

EXAMPLES

Hereinafter, the invention will be explained in detail by way of Examples, which are not intended to limit the invention.

1. Preparation of support

<Support A>

In order to remove any rolling oil from the surface of an aluminum sheet (material 1050) having a thickness of 0.3 mm, degreasing was carried out using a 10% by weight aqueous solution of sodium aluminate at 50°C for 30 seconds, and then the surface of the aluminum sheet was grained using three bundle-type nylon brushes with a hair diameter of 0.3 mm and an aqueous suspension (specific gravity 1.1 $g/cm^3$) of pumice stone with a median size of 25 μm, and washed thoroughly with water. This plate was etched by immersing it in a 25% by weight aqueous solution of sodium hydroxide at 45°C for 9 seconds, washed with water, and then immersed again in a 20% by weight of nitric acid at 60°C for 20 seconds, followed by washing with water. Here, the etched amount of the grained plate surface was about 3 $g/m^2$.

Next, electrochemical surface-roughening was carried out continuously using an alternating current of 60 Hz. Here, the electrolytic solution was a 1% by weight aqueous solution of nitric acid (containing 0.5% by weight of aluminum ions), and the solution temperature was 50°C. Using an alternating current of the trapezoid rectangular wave type with a waveform such as that the time taken by the current to reach from 0 to the peak value, TP, was 0.8 msec and the duty ratio was 1:1, the electrochemical surface-roughening treatment was carried out with a carbon electrode as the counter electrode. Ferrite was used as the auxiliary anode. The current density was 30 $A/dm^2$ as the current peak value, and 5% of the current flowing from the power supply was splitted into the auxiliary anode. The quantity of electricity in the nitric acid electrolysis was 175 $C/dm^2$ as the quantity of electricity when the anode was the aluminum sheet. Subsequently, water rinsing by spraying was carried out.

Next, in an electrolytic solution of a 0.5% by weight aqueous solution of hydrochloric acid (containing 0.5% by weight of aluminum ions) at the solution temperature of 50°C, and under the condition of the quantity of electricity 50 $C/dm^2$ of when the anode is the aluminum sheet, the electrochemical surface-roughening treatment was carried out in the same manner as in the above-mentioned nitric acid electrolysis, and then water rinsing by spraying was carried out. This plate was furnished thereon with 2.5 $g/m^2$ of direct current anodized film using a 15% by weight of sulfuric acid (containing 0.5% by weight of aluminum ions) as the electrolytic solution at a current density of 15 $A/dm^2$, subsequently rinsed with water, dried to yield support A.

<Support B>

As described for support A, a support furnished with an anodized film was immersed in a solution at pH 3.7 containing 0.1% by weight of sodium fluorozirconate and 1% by weight of sodium dihydrogen phosphate, which had been heated to 75°C, for 10 seconds, subjected to sealing, washed with water and dried to yield support B.

<Support C>

As described for support A, a support furnished with an anodized film was treated with a 1% by weight aqueous solution of sodium hydroxide at 60°C for 10 seconds to widen the pores in the anodized film. By this treatment, the pore diameter of the anodized film was increased to 20 nm.

After the pore-widening treatment, the support was immersed in a solution at pH 3.7 containing 0.1% by weight of sodium fluorozirconate and 1% by weight of sodium dihydrogen phosphate, which had been heated to 75°C, for 10 seconds, subjected to sealing, washed with water and dried to yield support C.

<Support D>

As described for support A, a support furnished with an anodized film was exposed to an atmosphere of saturated steam at 100°C for 10 seconds, subjected to sealing and dried to yield support D.

The above-mentioned supports A, B, C and D were respectively treated with a 2.5% by weight aqueous solution of sodium silicate at 30°C for 10 seconds. The centerline average roughness (Ra) values of these supports were measured using a needle with a diameter of 2 μm, and the values were all 0.51 μm.

Further, supports A to D were prepared for the use in the following experiments by applying Undercoat Solution (1) of the composition described below to a dry coating amount of 5 mg/$m^2$.

| | |
|---|---|
| Undercoat Solution (1) | |
| Undercoat compound (1) below | 0.017 g |
| Methanol | 9.06 g |
| Water | 1.00 g |

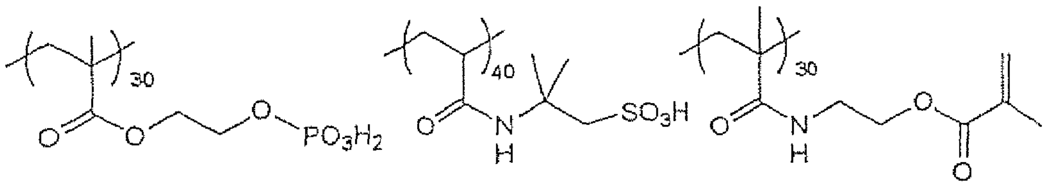

Undercoat Compound (1)

2. Preparation of lithographic printing plate precursor

Preparation of lithographic printing plate precursor (1) (photopolymer plate material)

On the aforementioned support B with an undercoat, a coating solution for image recording layer (1) of the following composition was applied to a dry coating mass of 1.5 g/$m^2$ and dried at 100°C for 1 minute to form an image recording layer. A coating solution for protective layer (1) of the following composition was applied on the image recording layer to a dry coating amount of 2.5 g/$m^2$ and dried at 120°C for 1 minute to yield a lithographic printing plate precursor (1).

<Coating solution for image recording layer (1)>

| | |
|---|---|
| tetramethylolmethane tetraacrylate | 20 g |
| Binder polymer (1) below (average M.W. 50,000) | 30 g |
| Polymerization initiator (1) below | 1 g |
| ε-phthalocyanine/Binder polymer (I) Dispersion | 2 g |
| Fluorine-based nonionic surfactant Megafack F177 (Dainippon Ink & Chemicals, Inc.) | 0.5 g |
| Cupferron AL (nitroso compound, Wako Pure Chemical Industries) | 0.2 g |
| Methyl ethyl ketone | 200 g |
| Propylene glycol monomethyl ether acetate | 200 g |

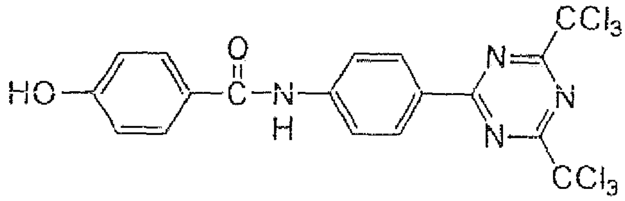

Polymerization Initiator (1)

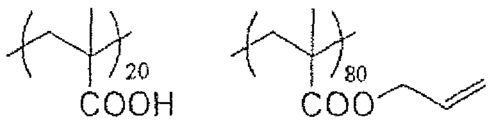

Binder Polymer (1)

<Coating solution for protective layer (1)>

| | |
|---|---|
| Polyvinyl alcohol (degree of saponification 95 mol%, degree of polymerization 800) | 40 g |
| Polyvinyl pyrrolidone (M. W. 50,000) | 5 g |
| Poly(vinyl pyrrolidone/vinyl acetate (1/1)) (M.W. 70,000) | 5 g |
| Water | 950 g |

Preparation of lithographic printing plate precursor (2) (plate material for on-press development)

On the support B coated with an undercoat, a coating solution for image recording layer (2) of the following composition was bar-coated, dried in an oven at 70°C for 60 seconds to for an image recording layer of a dry coating amount of 1.0 g/$m^2$. The aforementioned coating solution for protective layer (1) was coated thereon to a dry coating mass of 0.5 g/$m^2$, dried at 120°C for 1 minute to yield a lithographic printing plate precursor (2).

<Coating solution or image recording layer (2)>

| | |
|---|---|
| Polymerization initiator (1) above | 0.2 g |
| Binder polymer (2) below (average M. W. 80,000) | 6.0 g |
| Polymerizable compound Isocyanuric acid EO-modified triacrylate (Toagosei Co., Ltd., Aronix M-315) | 12.4 g |
| Leuco Crystal Violet | 3.0 g |
| Thermal polymerization inhibitor N-nitrosophenylhydroxylamin aluminum salt | 0.1 g |
| Tetraethylammonium chloride | 0.1 g |
| Fluorine-based surfactant (1) below | 0.1 g |
| Methyl ethyl ketone | 70.0 g |

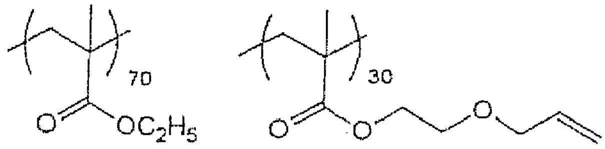

Binder Polymer (2)

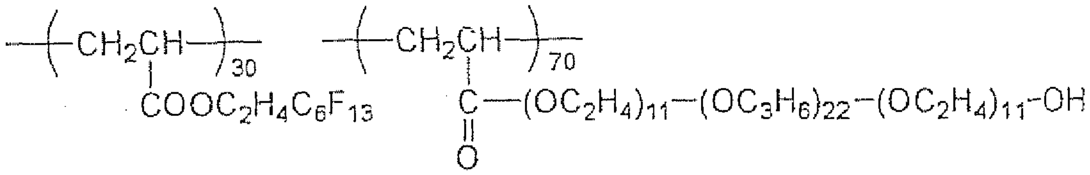

Fluorine-based surfactant (1)

Preparation of lithographic printing plate precursor (3) (microcapsule-type plate material for on-press development)

A lithographic printing plate precursor (3) was obtained in the same manner as in the preparation of the lithographic printing plate precursor (2), except that the aforementioned coating solution for image recording layer (2) was replaced by a coating solution for image recording layer (3) of the following composition.

<Coating solution for image recording layer (3)>

| | |
|---|---|
| Polymerization initiator (1) above | 0.2 g |
| Binder polymer (2) above (average M.W. 80,000) | 3.0 g |
| Polymerizable compound Isocyanuric acid EO-modified triacrylate (Toagosei Co., Ltd., Aronix M-315) | 6.2 g |
| Leuco Crystal Violet | 3.0 g |
| Thermal polymerization inhibitor N-nitrosophenylhydroxylamine aluminum salt | 0.1 g |
| Fluorine-based surfactant (1) above | 0.1 g |
| Microcapsules (1) below (in terms of solids content) | 10.0 g |
| Methyl ethyl ketone | 35.0 g |
| 1-Methoxy-2-propanol | 35.0 g |
| Water | 10.0 g |

(Synthesis of microcapsules (1))

For the oil phase components, 10 g of an adduct of trimethylolpropane and xylenediisocyanate (manufactured by Mitsui Takeda Chemicals, Inc., Takenate D-110N), 4.15 g of isocyanuric acid EO-modified diacrylate (manufactured by Toagosei Co., Ltd., Aronix M-215), and 0.1 g of Pionin A-41C (manufactured by Takemoto Oil&Fat Co., Ltd.) were dissolved in 17 g of ethyl acetate. For the aqueous phase component, 40 g of a 4% by weight aqueous solution of PVA-205 was prepared. The oil phase components and the aqueous phase component were mixed and emulsified using a homogenizer at 12,000 rpm for 10 minutes. Thus obtained emulsion was added to 25 g of distilled water, stirred at room temperature for 30 minutes, and further stirred at 40°C for 3 hours. Thus obtained microcapsule solution (1) was diluted

with distilled water to a solid concentration of 20% by weight. The average particle diameter was 0.25 μm.

Preparation of lithographic printing plate precursor (4) (plate material for on-press development, replacement of initiator)

A lithographic printing plate precursor (4) was obtained in the same manner as in the preparation of the lithographic printing plate precursor (2), except that the polymerization initiator (1) used in the preparation of the lithographic printing plate precursor (2) was replaced by the following polymerization initiator (2).

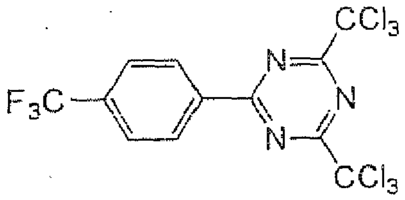

Polymerization Initiator (2)

Preparation of lithographic printing plate precursors (5) to (7) (plate material for on-press development, replacement of initiator)

Lithographic printing plate precursors (5) and (6) were obtained in the same manner as in the preparation of the lithographic printing plate precursor (2), except that the polymerization initiator (1) in the coating solution for image recording layer (2) was replaced by the following polymerization initiators (3) and (4), and 0.5 g of the following sensitizing dye (1) was added respectively. Further, a lithographic printing plate precursor (7) was obtained in the same manner as in the preparation of the lithographic printing plate precursor (2), except that the polymerization initiator (1) in the coating solution for image recording layer (2) was replaced by the following polymerization initiator (3), and 0.5 g of the following sensitizing dye (2) was further added.

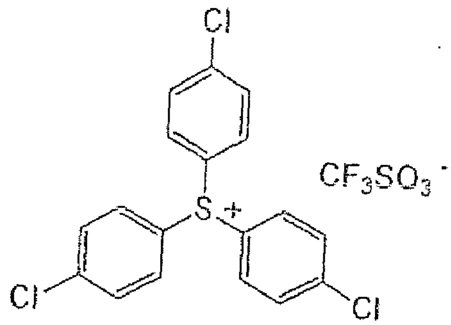

Polymerization Initiator (3)

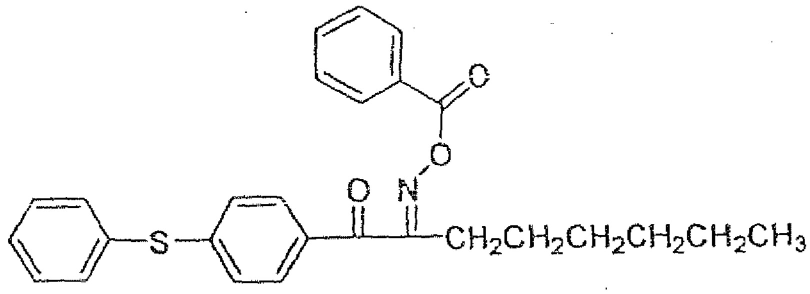

Polymerization Initiator (4)

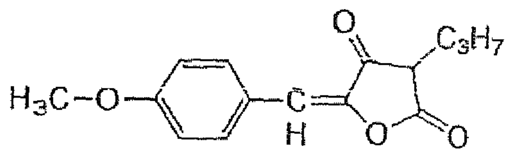

Sensitizing dye (1)

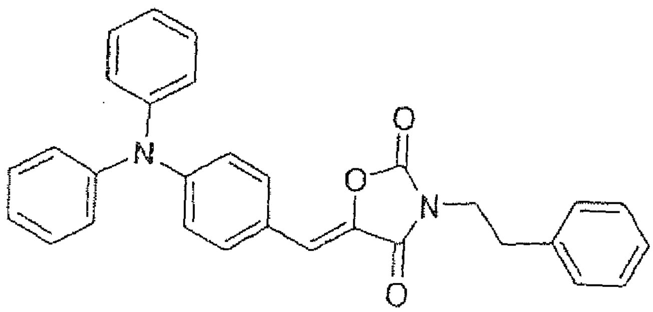

Sensitizing dye (2)

Preparation of lithographic printing plate precursors (8) and (9) (no protective layer)

In the preparation of the above lithographic printing plate precursors (1) and (2), the lithographic printing plate precursors prior to the application of a protective layer on the image recording layer were taken as lithographic printing plate precursors (8) and (9), respectively.

Preparation of lithographic printing plate precursor (10) (for Comparative Example)

A lithographic printing plate precursor (10) was obtained in the same manner as in the preparation of the lithographic printing plate precursor (2), except that the polymerization initiator (1) used in the lithographic printing plate precursor (2) was replaced by the following polymerization initiator (5) ($\lambda max$ = 510 nm).

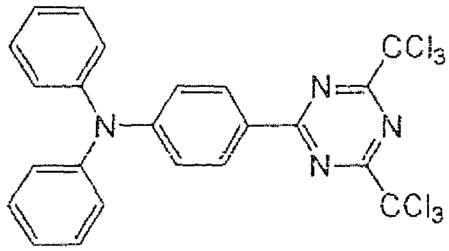

Polymerization Initiator (5)

Preparation of lithographic printing plate precursors (12) and (13) (replacement of support)

Lithographic printing plate precursors (12) and (13) were obtained in the same manner as in the preparation of the lithographic printing plate precursor (2), except that support B used in the lithographic printing plate precursor (2) was replaced by supports C and D, respectively.

Preparation of lithographic printing plate precursors (15) and (16) (replacement of support)

Lithographic printing plate precursors (15) and (16) were obtained in the same manner as in the preparation of the lithographic printing plate precursor (6), except that support B used in the lithographic printing plate precursor (6) was replaced by supports C and D, respectively.

Preparation of lithographic printing plate precursors (18) and (19) (replacement of support)

Lithographic printing plate precursors (18) and (19) were obtained in the same manner as in the preparation of the lithographic printing plate precursor (7), except that support B used in the lithographic printing plate precursor (7) was replaced by supports C and D, respectively.

[Examples 1 to 20]

Using the lithographic printing plate precursors (1) to (9), (12), (13), (15), (16), (18) and (19) as prepared in the above, image formation and printing were carried out to evaluate sensitivity, fine line reproducibility and safety under white light. Hereinafter, the methods for exposure, development, printing and evaluation used respectively are presented. Also, Table 1 presents a lithographic printing plate precursor used in each Example, a support, presence or absence of a protective layer, an absorption maximum wavelength of the polymerization initiator used, a light source, an imaging time per pixel and evaluation results.

[Comparative Examples 1 and 2]

Evaluation on exposure and printing was carried out in the same manner as in Example 2, except that the imaging time per pixel was changed as described in Table 1. The results are presented in Table 1.

[Comparative Example 3]

Evaluation on exposure and printing was carried out in the same manner as in Example 2, except that the lithographic printing plate precursor (10) was used, the laser used was changed to a 488 nm Ar laser, and the imaging time per pixel was changed as described in Table 1. The results are presented in Table 1.

(1) Method for exposure

<For Examples 1 to 3 and 5 to 17, 19, and 20 and Comparative Examples 1>

The lithographic printing plate precursors were exposed using an exposing head which consists of an optical system using a DMD space modulation element as illustrated in Fig. 6, with a 375 nm or 405 nm (Examples 7, 14, 15 and 20) semiconductor laser, an outer surface drum of a perimeter of 900 mm, at a resolution of 2400 dpi, after adjustment of the drum rotation speed and laser output that can result in the imaging time per pixel and exposure energy as described in Table 1.

<For Examples 4 and 18>

The lithographic printing plate precursors were exposed using a 266 nm laser (Example 4) whose wavelength is four-fold of the YAG oscillating mode-locked solid laser in Fig. 4, and a 355 nm laser (Example 18) whose wavelength is three-fold of the YAG oscillating solid laser, under the conditions of the inner drum mode and a resolution of 2400 dpi, after adjustment of the spindle minor rotating speed and laser output that can result in the imaging time per pixel and exposure energy as described in Table 1.

<For Comparative Examples 2 and 3>

In order to expose the lithographic printing plate precursors for 1 second, a 375 nm semiconductor laser (Comparative Example 2) or a 488 nm argon ion laser (Comparative Example 3) were used to diffuse the light into beams of a diameter of 100 mm in a lens system, and wide exposure was carried out. Exposure was done after adjustment of the laser output and exposure time to obtain the image-forming time and exposure energy as described in Table 1. Further, in evaluation of the fine line reproducibility, exposure was carried out using a testchart as the mask.

(2) Development treatment

The development treatment for the lithographic printing plate precursors (1) and (8) were carried out by immersing the plate precursors in a developer prepared by diluting the DP-4 Developer (manufactured by Fuji Photo Film Co., Ltd.) with water to 18 times, at 30°C for 15 seconds. Next, the plate surfaces were treated with a twofold dilution of GU-7 rubber solution (manufactured by Fuji Photo Film Co., Ltd.) in water,

For the lithographic printing plate precursors (2) to (7) and (9) to (19), the on-press development was carried out without subjecting the readily exposed plate precursors to development treatment as described in the following method for printing.

For the lithographic printing plate precursors (6) and (7), apart from the above-mentioned development treatment, the plate precursors were subjected to friction treatment on the plate surface with a developing pad impregnated with the following developer (1) and then washed with water (Examples 19 and 20). Further, the developer (1) was at a temperature of 35°C and at pH 9 or less.

| Developer (1) | |
|---|---|
| Water | 100 g |
| Benzyl alcohol | 1 g |
| Polyoxyethylene sorbitan monooleate (HLB = 10.0) | 1 g |
| Sodium salt of dioctylsulfosuccinic acid ester | 0.5 g |
| Gum arabic | 1.5 g |
| Phosphoric acid | 0.1 g |

(3) Method for printing

The lithographic printing plate precursors (I) and (8) were subjected to the development treatment and then to printing as mounted on a printing press SOR-M manufactured by Heidelberg Druckmaschinen AG, using a fountain solution (EU-3 (etching solution manufactured by Fuji Photo Film Co., Ltd.)/water/isopropyl alcohol=1/89/10 (volume ratio)) and TRANS-G (N) black ink (manufactured by Dainippon Ink & Chemicals, Inc.) at a printing speed of 6000 sheets per hour.

The lithographic printing plate precursors (2) to (7) and (9) to (19) were subjected to printing, without the

development treatment of the obtained readily exposed plate precursors, as mounted on a cylinder of a printing press SOR-M manufactured by Heidelberg Druckmaschinen AG, respectively, and after supplying a fountain solution and ink using a fountain solution (IF201 (etching solution manufactured by Fuji Photo Film Co., Ltd.)/water = 4/96 (volume ratio)) and TRANS-G (N) black ink (manufactured by Dainippon Ink & Chemicals, Inc.) at a printing speed of 6000 sheets per hour, to print 100 sheets in total. The removal of the unexposed area from the image recording layer was completed on the printing press, and thus printouts with no ink contamination in the non-image area could be obtained.

(4) Evaluation of lithographic printing plate precursor

<Sensitivity>

After it was confirmed by carrying out printing of 100 sheets that printouts with no ink contamination in the non-image area could be obtained, printing of another 500 sheets was carried out subsequently. On the 600th printout, the minimum amount of exposure with no fluctuation in the ink concentration at the image area was measured as the sensitivity.

<Fine line reproducibility>

With regard to the lithographic printing plate precursors that were exposed in an amount of exposure determined by the above sensitivity evaluation, as described above, after it was confirmed by carrying out printing of 100 sheets that printouts with no ink contamination in the non-image area could be obtained, printing of another 500 sheets was carried out subsequently. A fine line chart (a chart exposed under fine lines of 10, 12, 14, 16, 18, 20, 25, 30, 35, 40, 60, 80, 100 and 200 μm) on the 600th printout was observed with a loupe of 25 magnifications, and the fine line reproducibility was evaluated by the fine line width reproduced with ink without interruption.

<Safety under white light>

Unexposed lithographic printing plate precursors were placed under a white fluorescent light which was installed under the condition that the intensity of light at the lithographic printing plate precursor surface was 400 lux, and the printing precursors were irradiated. These lithographic printing plate precursors exposed under a white light were optionally subjected to development depending on necessity, and as described above, they were mounted on a cylinder of a printing press SOR-M manufactured by Heidelberg Druckmaschinen AG for printing of 100 sheets. Subsequently, the time for irradiation under a white fluorescent light without ink contamination was measured. As this time was longer, the safety under white light could be considered good.

Table 1

| | Lithographic printing plate precursor | Support | Protective layer | Light source | Imaging time per pixel | Absorption Maximum of Initiator λmax [nm] | Sensitivity [mJ/cm$^2$ | Fine line Reproducibility [μm] | Safety under white light [min] |
|---|---|---|---|---|---|---|---|---|---|
| Example 1 | (1) | B | present | 375 nm semiconductor laser | 20 μsec | 360 | 0.05 | 10 | 180 |
| Example 2 | (2) | B | present | 375 nm semiconductor laser | 20 μsec | 360 | 0.08 | 12 | 200 |
| Example 3 | (3) | B | present | 375 nm semiconductor laser | 20 μsec | 360 | 0.10 | 12 | 200 |
| Example 4 | (4) | B | present | 266 nm laser | 0.02 μsec | 267 | 0.05 | 10 | 240 |
| Example 5 | (5) | B | present | 375 nm semiconductor laser | 0.9 μsec | 375 | 0.17 | 14 | 300 |
| Example 6 | (6) | B | present | 375 nm semiconductor laser | 20 μsec | 375 | 0.10 | 12 | 300 |
| Example 7 | (7) | B | present | 405 nm semiconductor laser | 20 μsec | 405 | 0.20 | 14 | 240 |
| Example 8 | (8) | B | absent | 375 nm semiconductor laser | 20 μsec | 360 | 0.25 | 12 | 240 |
| Example 9 | (9) | B | absent | 375 nm semiconductor laser | 100 μsec | 360 | 0.15 | 12 | 320 |
| Example 10 | (12) | C | present | 375 nm semiconductor laser | 20 μsec | 360 | 0.10 | 14 | 240 |

(continued)

| | Lithographic printing plate precursor | Support | Protective layer | Light source | Imaging time per pixel | Absorption Maximum of Initiator λmax [nm] | Sensitivity [mJ/cm$^2$ | Fine line Reproducibility [μm] | Safety under white light [min] |
|---|---|---|---|---|---|---|---|---|---|
| Example 11 | (13) | D | present | 375 nm semiconductor laser | 20 μsec | 360 | 0.06 | 10 | 180 |
| Example 12 | (15) | C | present | 375 nm semiconductor laser | 20 μsec | 375 | 0.12 | 14 | 300 |
| Example 13 | (16) | D | present | 375 nm semiconductor laser | 20 μsec | 375 | 0.09 | 12 | 240 |
| Example 14 | (18) | C | present | 405 nm semiconductor laser | 20 μsec | 405 | 0.20 | 16 | 240 |
| Example 15 | (19) | D | present | 405 nm semiconductor laser | 20 μsec | 405 | 0.15 | 12 | 200 |
| Example 16 | (1) | B | present | 375 nm semiconductor laser | 100 μsec | 360 | 0.08 | 12 | 180 |
| Example 17 | (2) | B | present | 375 nm semiconductor laser | 1 msec | 360 | 0.10 | 12 | 200 |
| Example 18 | (2) | B | present | 355 nm laser | 0.1 μsec | 360 | 0.10 | 12 | 200 |
| Example 19 | (6) | B | present | 375 nm semiconductor laser | 20 μsec | 375 | 0.12 | 12 | 300 |
| Example 20 | (7) | B | present | 405 nm semiconductor laser | 20 μsec | 405 | 0.22 | 14 | 240 |

(continued)

| | Lithographic printing plate precursor | Support | Protective layer | Light source | Imaging time per pixel | Absorption Maximum of Initiator λmax [nm] | Sensitivity [mJ/cm$^2$ | Fine line Reproducibility [μm] | Safety under white light [min] |
|---|---|---|---|---|---|---|---|---|---|
| Com. Ex. 1 | (2) | B | present | 375 nm semiconductor laser | 2 msec | 360 | 1.00 | 20 | 200 |
| Com. Ex. 2 | (2) | B | present | 375 nm semiconductor laser | 1 sec | 360 | 1.50 | 40 | 200 |
| Com. Ex. 3 | (10) | B | present | 488 nm laser | 1 sec | 510 | 20 | 40 | 5 |

As it can be seen from the results described above, the image recording method and the lithographic printing method of the invention exhibit high sensitivity and safety under white light, and provide high image quality and good fine line reproducibility.

Examples 21 and 22

Preparation of lithographic printing plate precursor (21)

1. Preparation of support

A melt of JIS A1050 aluminum alloy containing 99.5% by weight or more of Al, 0.30% by weight of Fe, 0.10% by weight of Si, 0.02% by weight of Ti, 0.013% by weight of Cu, and the remaining being inevitable impurities, was subjected to purification and casting, The purification process was carried out by degassing in order to remove unnecessary gases such as hydrogen and the like from the melt and by filtering through a ceramic tube filter. The cast molding process was carried out by direct current casting. An ingot in the form of solidified sheet having a thickness of 500 mm was subjected to milling of the surface to a depth of 10 mm, and it was homogenized at 550°C for 10 hours in order to prevent grain coarsening in the intermetallic compounds. Subsequently, the ingot was subjected to hot rolling at 400°C, to process annealing in a continuous annealing furnace at 500°C for 60 seconds, and to cold rolling, to yield an aluminum rolled sheet with a thickness of 0.30 mm. By controlling the roughness of the rolling roll, the centerline average roughness (Ra) after cold rolling was controlled to 0.2 μm. Then, the sheet was treated with a tension leveler to improve planarity. Thus obtained aluminum sheet was subjected to the surface treatment as described below.

In order to remove any rolling oil from the surface of the aluminum sheet, degreasing was carried out using a 10% by weight aqueous solution of sodium aluminate at 50°C for 30 seconds, and then the surface of the aluminum sheet was grained using three bundle-type nylon brushes with a hair diameter of 0.3 mm and an aqueous suspension (specific gravity 1.1 g/cm$^3$) of pumice stone with a median size of 25 μm, and washed thoroughly with water. This sheet was etched by immersing it in a 25% by weight aqueous solution of sodium hydroxide at 45°C for 9 seconds, washed with water, and then immersed again in a 20% by weight of nitric acid at 60°C for 20 seconds, followed by washing with water. Here, the etched amount of the grained sheet surface was about 3 g/m$^2$.

Next, electrochemical surface-roughening was carried out continuously using an alternating current of 60 Hz. Here, the electrolytic solution was a 1% by weight aqueous solution of nitric acid (containing 0.5% by weight of aluminum ions), and the solution temperature was 50°C. Using an alternating current of the trapezoid rectangular wave type with a waveform such as that the time taken by the current to reach from 0 to the peak value, TP, was 0.8 msec and the duty ratio was 1:1, the electrochemical surface-roughening treatment was carried out with a carbon electrode as the counter electrode. Ferrite was used as the auxiliary anode. The current density was 30 A/dm$^2$ as the current peak value, md 5% of the current flowing from the power supply was splitted into the auxiliary anode. The quantity of electricity in the nitric acid electrolysis was 175 C/dm$^2$ as the quantity of electricity when the anode was the aluminum sheet. Subsequently water rinsing by spraying was carried out.

Next, in an electrolytic solution of a 0.5% by weight aqueous solution of hydrochloric acid (containing 0.5% by weight of aluminum ions) at the solution temperature of 50°C, and under the condition of the quantity of electricity 50 C/dm$^2$ of when the anode is the aluminum sheet, the electrochemical surface-roughening treatment was carried out in the same manner as in the above-mentioned nitric acid electrolysis, and then water rinsing by spraying was carried out. This sheet was furnished thereon with 2.5 g/m$^2$ of direct current anodized film using a 15% by weight of sulfuric acid (containing 0.5% by weight of aluminum ions) as the electrolytic solution at a current density of 15 A/dm$^2$, subsequently rinsed with water, dried, and again treated with a 2.5% by weight aqueous solution of sodium silicate at 30°C for 10 seconds. The centerline average roughness (Ra) of this substrate was 0.51 μm, when measured using a needle with a diameter of 2 μm.

On the above-described support, a coating solution for undercoat layer (21) of the following composition was applied using a bar to a liquid amount of 7.5 ml/m$^2$ and then dried in an oven at 80°C for 10 seconds. A coating solution for image recording layer (21) of the following composition was bar-coated and then dried in an oven at 70°C for 60 seconds to form an image recording layer of a dry coating amount of 1.0 g/m$^2$. The following coating solution for protective layer (1) was coated thereon to a dry coating mass of 0.5 g/m$^2$, dried at 120°C for 1 minute to yield a lithographic printing plate precursor (21).

<Coating solution for undercoat layer (21)>

| | |
|---|---|
| • Water | 300 g |
| • Methanol | 2700 g |
| • Compound C-1 below | 1.45 g |
| <Coating solution for image recording layer (21)> | |
| • Polymerization initiators (4) below | 0.2 g |
| • Binder polymer (2) below (average M.W. 80,000) | 6.0 g |
| • Polymerizable compound Isocyanuric acid EO-modified triacrylate (Toagosei Co., Ltd., M-315) | 12.4 g |
| • Leuco Crystal Violet | 3.0 g |
| • Thermal polymerization inhibitor N-nitrosophenylhydroxylamine aluminum salt | 0.1 g |
| • Sensitizing dye (1) below | 0.5 g |
| • Tetraethylammonium chloride | 0.1 g |
| • Fluorine-based surfactant (1) below | 0.1 g |
| • Methyl ethyl ketone | 70.0 g |

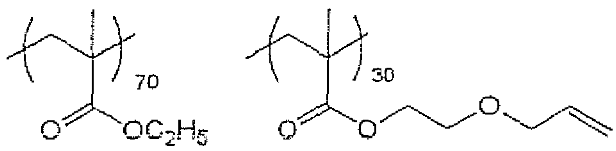

Binder Polymer (2)

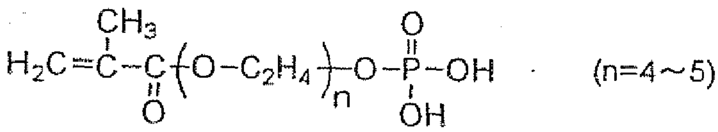

Compound C-1

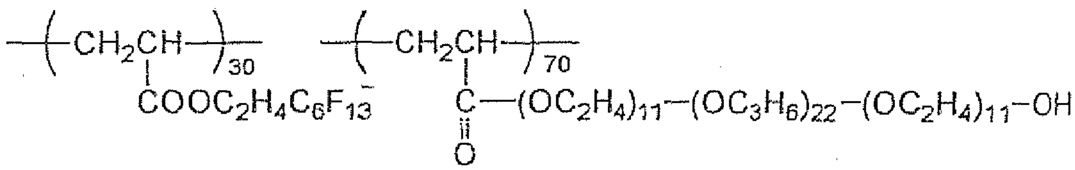

Fluorine-based surfactant (1)

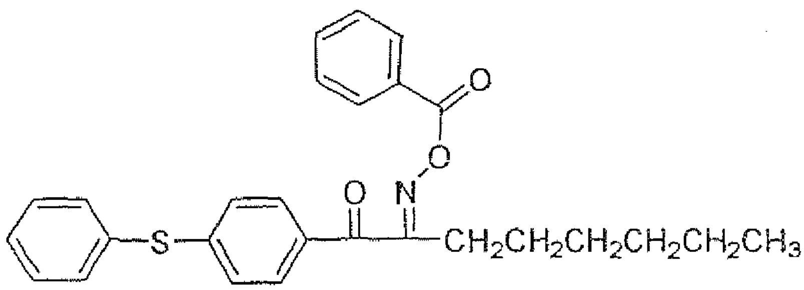

Polymerization Initiator (4)

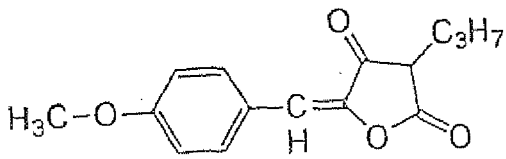

Sensitizing dye (1)

<Coating solution for protective layer (1)>

| | |
|---|---|
| • Polyvinyl alcohol (degree of saponification 95 mol%, degree of polymerization 800) | 40 g |
| • Polyvinyl pyrrolidone (M.W. 50,000) | 5 g |
| • Poly(vinyl pyrrolidone/vinyl acetate (1/1) M.W. 70,000) | 5 g |
| • Water | 950 g |

Preparation of lithographic printing plate precursor (22)

A lithographic printing plate precursor (22) was obtained in the same manner as in the preparation of the lithographic printing plate precursor (21), except that the polymerization initiators (4) in the coating solution for image recording layer (21) was replaced by the polymerization initiator (3) below, and 0.5 g of the following sensitizing dye (2) was further added in place of the sensitizing dye (1).

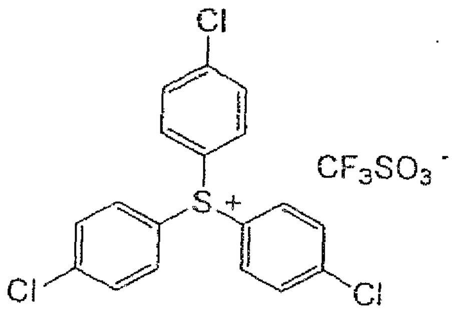

Polymerization Initiator (3)

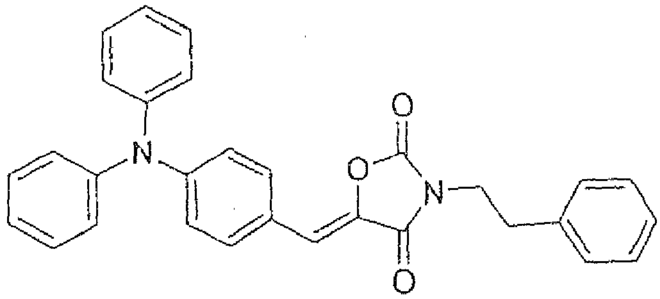

Sensitizing dye (2)

[Examples 21 and 22]

Using the lithographic printing plate precursors (21) to (22) as prepared in the above, image formation and printing were carried out to evaluate sensitivity, fine line reproducibility and safety under white light. Hereinafter, the methods for exposure, development, printing and evaluation used respectively are presented. Also, Table 2 presents the lithographic printing plate precursor used in each Example and the evaluation results.

(1) Method for exposure

<Examples 21 and 22>

The lithographic printing plate precursors were exposed using an exposing head which consists of an optical system using a DMD space modulation element as illustrated in Fig. 6, with a 375 nm (Example 21) or 405 nm (Example 22) semiconductor laser, an outer surface drum of a perimeter of 900 mm, at a resolution of 2400 dpi, after adjustment of the drum rotation speed and laser output that can result in the image-forming time per pixel and exposure energy as described in Table 2.

The development treatment for the lithographic printing plate precursors (21) and (22) was carried out in the same manner as in the Examples 19 and 20. The plate precursors were subjected to friction treatment on the plate surface with a developing pad impregnated with the above developer (1) and then washed with water (Examples 21 and 22). Further, the developer (1) was at a temperature of 35°C and at pH 9 or less.

The lithographic printing plate precursors were subjected then to printing as mounted on a printing press SOR-M manufactured by Heidelberg Druckmaschinen AG, using a fountain solution (EU-3 (etching solution manufactured by Fuji Photo Film Co., Ltd.)/water/isopropyl alcohol = 1/89/10 (volume ratio)) and TRANS-G (N) black ink (manufactured by Dainippon Ink & Chemicals, Inc.) at a printing speed of 6000 sheets per hour.

Table 2

| | Lithographic printing plate precursor | OC layer | Light source | Pixel residence time | Absorption Maximum of Initiator λ max[nm] | Sensitivity [$mJ/cm^2$] | Fine Line Reproducibility [μm] | Safety under white light [min] |
|---|---|---|---|---|---|---|---|---|
| Example 21 | (21) | present | 375 nm semiconductor laser | 20 μsec | 375 | 0.17 | 12 | 240 |
| Example 22 | (22) | present | 405 nm semiconductor laser | 20 μsec | 405 | 0.22 | 12 | 240 |

As it can be seen from the results described above, the image recording method and lithographic printing method (Examples 21 and 22) of the invention provide high image quality and good fine line reproducibility, exhibiting high sensitivity and safety under white light.

Industrial Applicability

According to the invention, it is possible to provide an image recording method and a lithographic printing method wherein both high sensitivity and safety under white light can be achieved, and high image quality with good fine line reproducibility can be obtained.

## Claims

1. A platemaking method of a lithographic printing plate, comprising developing with friction an exposed lithographic printing plate precursor with a developer, wherein the exposed lithographic printing plate precursor is obtained by an image recording method comprising imagewise exposing a lithographic printing plate precursor with an imaging time per pixel of 1 millisecond or less using a laser light with an emission wavelength of from 250 nm to 420 nm, wherein the lithographic printing plate precursor comprises a support and an image recording layer, in which the image recording layer contains (A) a polymerization initiator and (B) a polymeric compound and is photosensitive in a wavelength of from 250 nm to 420 nm;
wherein the developer is a non-alkaline developer having a pH value of from 2 to 10,
the support has an undercoat layer containing a compound that contains a polymerizable group and a support adherent group on the support, and
the lithographic printing plate after developed with friction is optionally subjected to washing, drying and desensitizing treatment.

2. The platemaking method according to claim 1, wherein the polymerizable group is selected from the group consisting of a methacryl group and an allyl group.

3. The platemaking method according to claim 1 or 2, wherein the support adherent group is selected from the group consisting of a sulfonic acid group, a phosphoric acid group and a phosphoric acid ester.

4. The platemaking method according to any of claims 1 to 3, wherein the compound contained in the undercoat layer has a hydrophilicity-imparting group.

5. The platemaking method according to claim 4, wherein the hydrophilicity-imparting group is an ethyleneoxy group.

6. The platemaking method according to any one of claims 1 to 5, wherein an amount of coating of the undercoat layer is from 1 to 30 mg/m$^2$.

7. The platemaking method according to any of claims 1 to 6, wherein the undercoat layer contains a compound represented by the following formula:

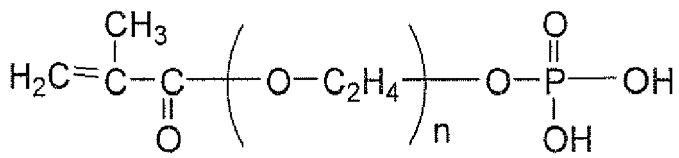

wherein n represents 4 to 5.

8. The platemaking method according to any of claims 1 to 7, wherein the undercoat layer consists of a compound that contains a polymerizable group and a support adherent group.

9. The platemaking method according to any of claims 1 to 8, wherein the developer contains a surfactant.

10. The platemaking method according to any of claims 1 to 9, wherein the developer contains a water-soluble polymeric compound.

11. The platemaking method according to any of claims 1 to 10, wherein the developer contains an organic solvent.

12. The platemaking method according to any of claims 1 to 11, wherein the image recording layer further contains (C) a binder polymer having an ethylenic unsaturated bond in a main chain or a side chain of the binder polymer (C).

13. The platemaking method according to claim 12, wherein the binder polymer (C) does not have an acid group.

14. The platemaking method according to claim 12, wherein a content of an unsaturated double bond in the ethylenic unsaturated bond is from 0.1 to 10.0 mmol relative to 1 gram of the binder polymer.

FIG. 1

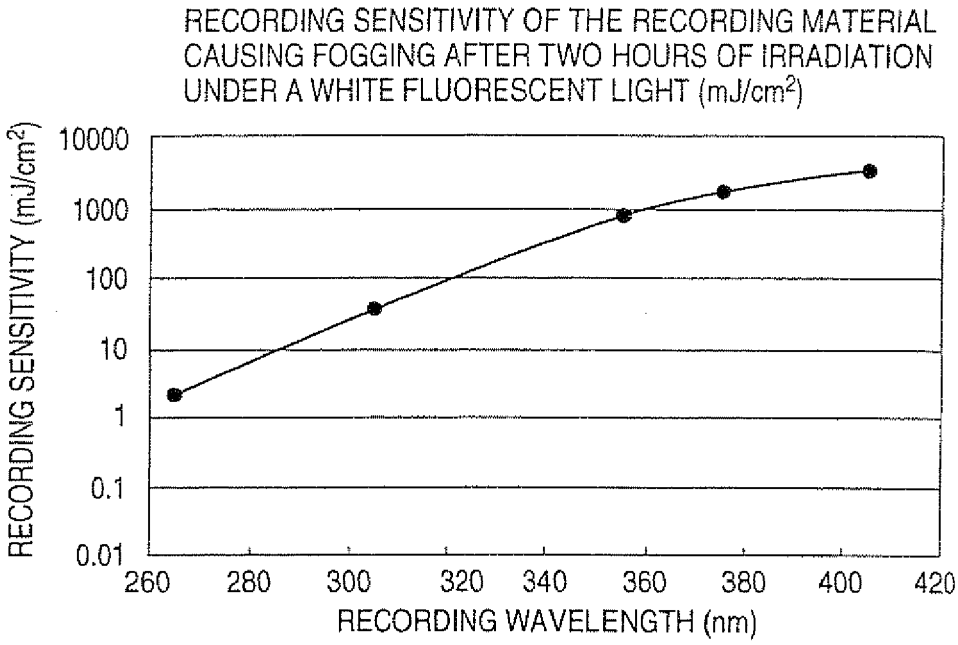
RECORDING SENSITIVITY OF THE RECORDING MATERIAL CAUSING FOGGING AFTER TWO HOURS OF IRRADIATION UNDER A WHITE FLUORESCENT LIGHT (mJ/cm2)
RECORDING SENSITIVITY (mJ/cm2)
10000
1000
100
10
1
0.1
0.01
260
280
300
320
340
360
380
400
420
RECORDING WAVELENGTH (nm)

FIG. 2

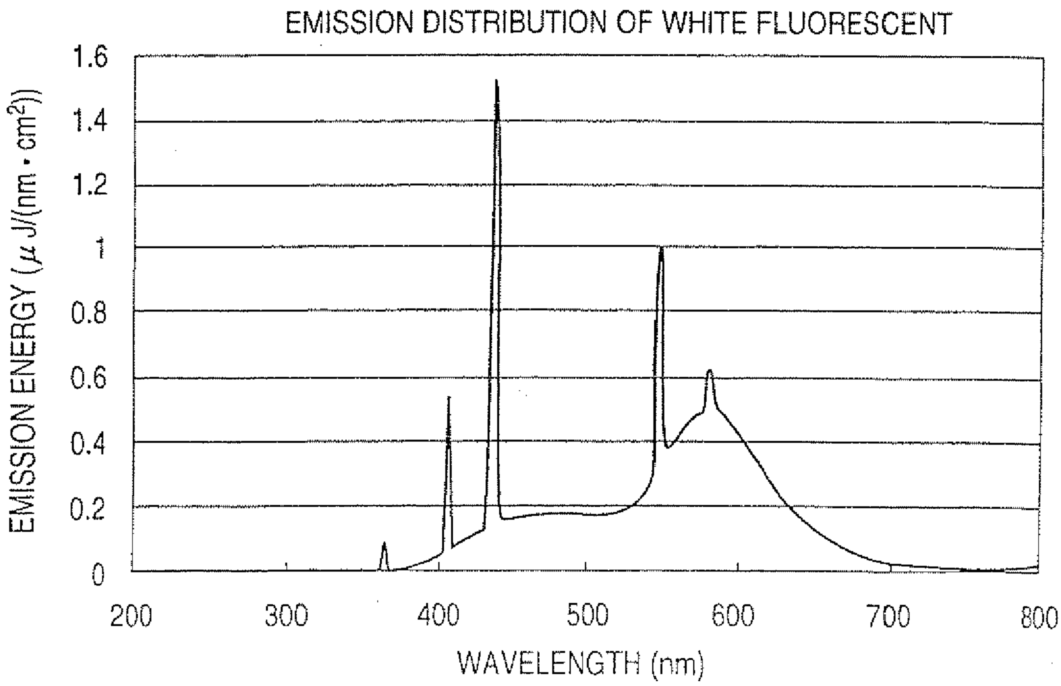
EMISSION DISTRIBUTION OF WHITE FLUORESCENT
EMISSION ENERGY (μJ/(nm • cm2))
1.6
1.4
1.2
1
0.8
0.6
0.4
0.2
0
200
300
400
500
600
700
800
WAVELENGTH (nm)

FIG. 3

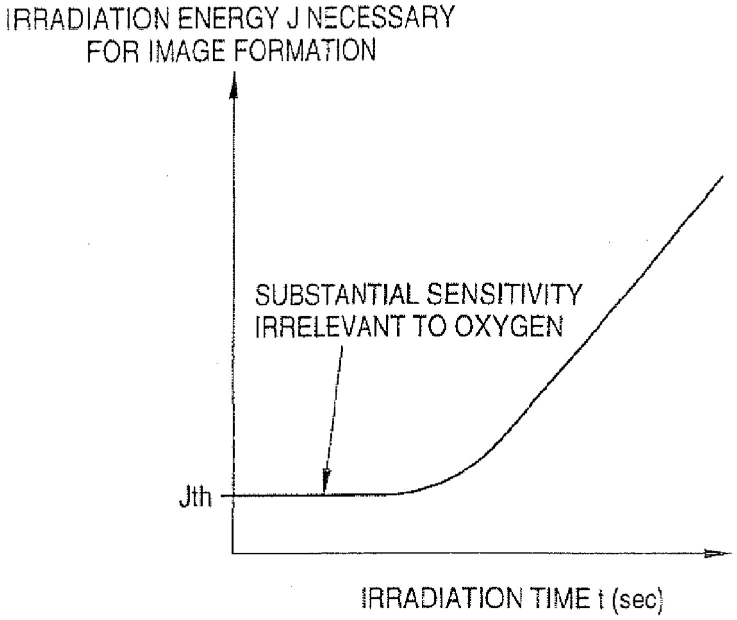
IRRADIATION ENERGY J NECESSARY FOR IMAGE FORMATION
SUBSTANTIAL SENSITIVITY IRRELEVANT TO OXYGEN
Jth
IRRADIATION TIME t (sec)

FIG. 4

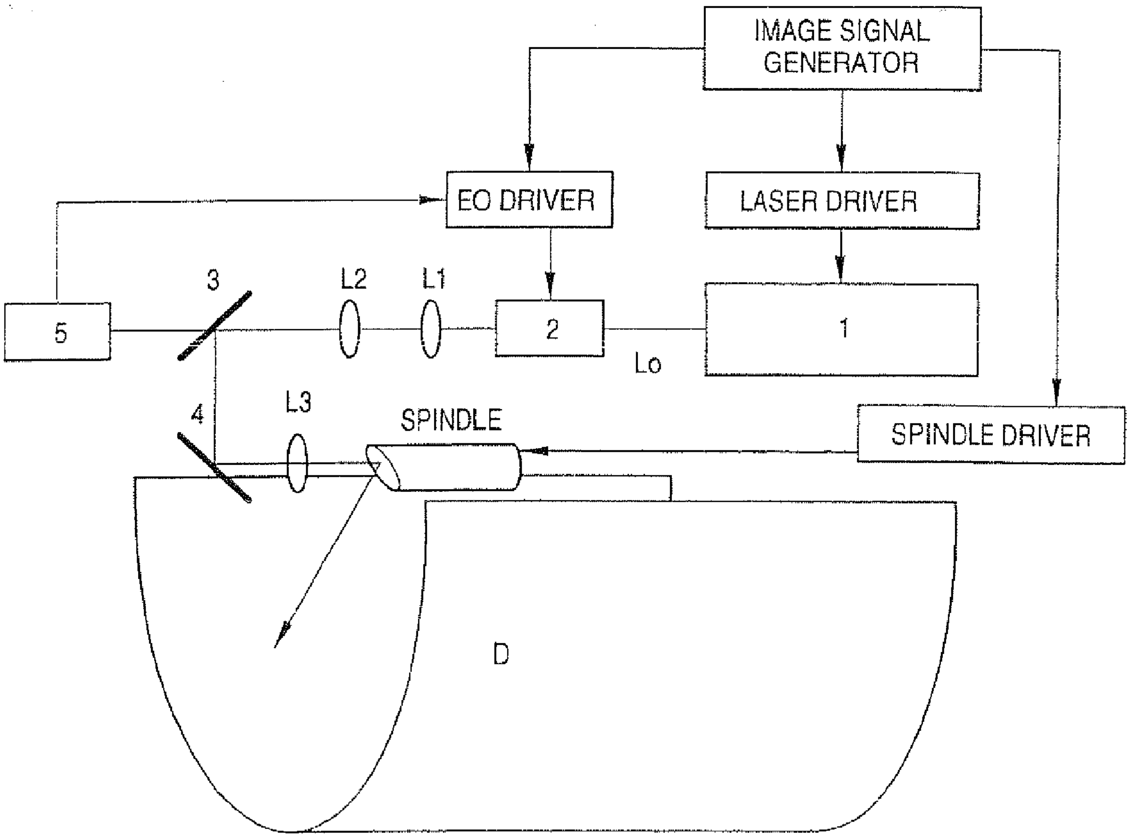
IMAGE SIGNAL GENERATOR
EO DRIVER
LASER DRIVER
3
L2
L1
5
2
1
Lo
4
L3
SPINDLE
SPINDLE DRIVER
D

FIG. 5 (a)

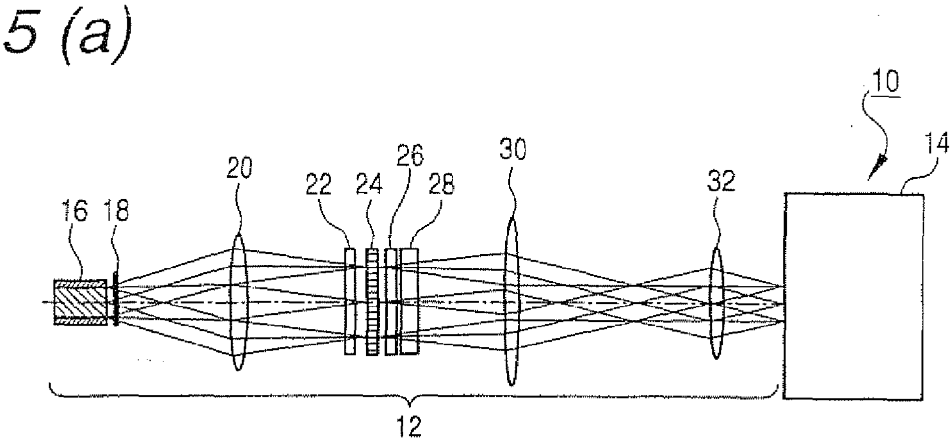


FIG. 5 (b)

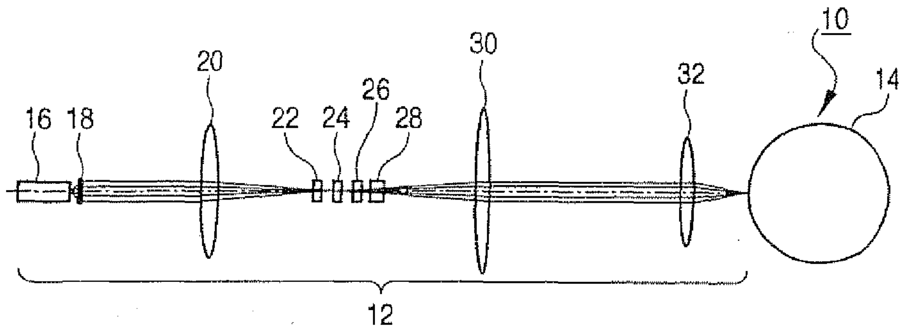


FIG. 6

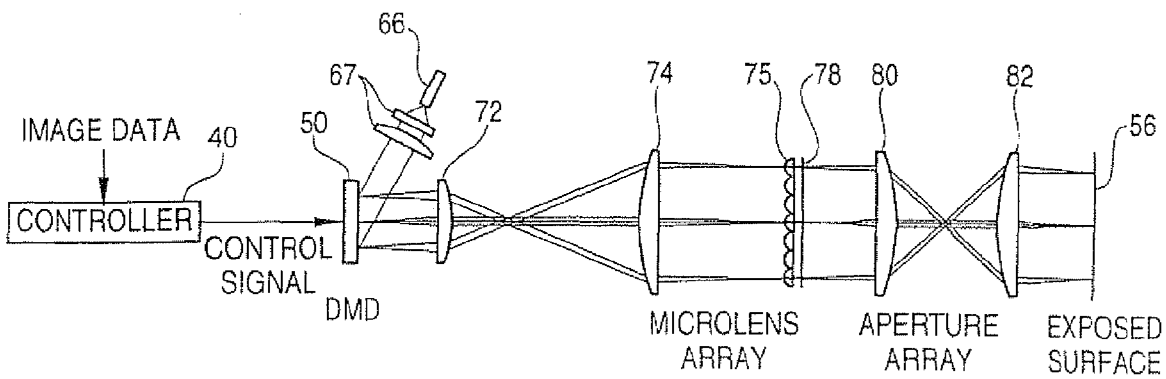

Europäisches Patentamt
European Patent Office
Office européen des brevets

# EUROPEAN SEARCH REPORT

Application Number
EP 10 15 9473

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 1 099 984 A (KODAK POLYCHROME GRAPHICS COMPANY LTD) 16 May 2001 (2001-05-16) * paragraphs [0070], [0065], [0066], [0038], [0031], [0029] * | 1-14 | INV. G03F7/20 G03F7/11 G03F7/085 |
| Y | EP 1 091 251 A2 (FUJI PHOTO FILM CO LTD [JP]) 11 April 2001 (2001-04-11) * examples comp.5,6 * | 1-14 | |
| A | EP 0 851 299 A1 (MITSUBISHI CHEM CORP [JP]) 1 July 1998 (1998-07-01) * claims 1-3 * | 1-14 | |
| A,P | EP 1 495 866 A2 (FUJI PHOTO FILM CO LTD [JP] FUJIFILM CORP [JP]) 12 January 2005 (2005-01-12) * the whole document * | 1-14 | |
| A | US 4 039 722 A (DICKIE RAY A ET AL) 2 August 1977 (1977-08-02) * the whole document * | 1-14 | |

TECHNICAL FIELDS SEARCHED (IPC)

G03F
B41N

The present search report has been drawn up for all claims

| Place of search | Date of completion of the search | Examiner |
|---|---|---|
| The Hague | 16 September 2010 | Haenisch, Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

2

EPO FORM 1503 03.82 (P04C01)

## ANNEX TO THE EUROPEAN SEARCH REPORT ON EUROPEAN PATENT APPLICATION NO. EP 10 15 9473

This annex lists the patent family members relating to the patent documents cited in the above-mentioned European search report.
The members are as contained in the European Patent Office EDP file on
The European Patent Office is in no way liable for these particulars which are merely given for the purpose of information.

16-09-2010

| Patent document cited in search report | | Publication date | Patent family member(s) | | | Publication date |
|---|---|---|---|---|---|---|
| EP 1099984 | A | 16-05-2001 | WO | 0043837 | A1 | 27-07-2000 |
| | | | JP | 2000275864 | A | 06-10-2000 |
| | | | US | 6426173 | B1 | 30-07-2002 |
| EP 1091251 | A2 | 11-04-2001 | US | 6558873 | B1 | 06-05-2003 |
| EP 0851299 | A1 | 01-07-1998 | DE | 69703378 | D1 | 30-11-2000 |
| | | | DE | 69703378 | T2 | 23-05-2001 |
| | | | US | 6514668 | B1 | 04-02-2003 |
| EP 1495866 | A2 | 12-01-2005 | AT | 430027 | T | 15-05-2009 |
| | | | CN | 1577087 | A | 09-02-2005 |
| | | | JP | 4418714 | B2 | 24-02-2010 |
| | | | JP | 2005041206 | A | 17-02-2005 |
| | | | US | 2005008971 | A1 | 13-01-2005 |
| US 4039722 | A | 02-08-1977 | NONE | | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000035673 A
- JP 2003158332 A
- JP 2004012899 A
- JP 2000168136 A
- JP 2001162866 A
- JP 54062004 A
- JP 57007427 B
- JP 54008002 A
- JP 55115045 A
- JP 59058431 A
- JP 2220061 A
- JP 60059351 A
- US 5148746 A
- US 5568768 A
- GB 2297719 A
- US 3905815 A
- JP 46004605 B
- JP 48036281 A
- JP 53133428 A
- JP 55032070 A
- JP 60239736 A
- JP 61169835 A
- JP 61169837 A
- JP 62058241 A
- JP 62212401 A
- JP 63070243 A
- JP 63298339 A
- JP 8108621 A
- JP 59152396 A
- JP 61151197 A
- JP 63041484 A
- JP 2000249 A
- JP 2004705 A
- JP 5083588 A
- JP 1304453 A
- JP 1152109 A
- JP 6029285 B
- US 3479185 A
- US 4311783 A
- US 4622286 A
- JP 62143044 A
- JP 62150242 A
- JP 9188685 A
- JP 9188686 A
- JP 9188710 A
- JP 2000131837 A
- JP 2002107916 A
- JP 2764769 B
- JP 2002116539 A
- JP 6157623 A
- JP 6175564 A
- JP 6175561 A
- JP 6175554 A
- JP 6175553 A
- JP 6348011 A
- JP 7128785 A
- JP 7140589 A
- JP 7306527 A
- JP 7292014 A
- JP 61166544 A
- JP 2003328465 A
- JP 2000066385 A
- JP 2000080068 A
- US 4069055 A
- JP 4365049 A
- US 4069056 A
- EP 104143 A
- US 339049 A
- US 410201 A
- JP 2150848 A
- JP 2296514 A
- EP 370693 A
- EP 390214 A
- EP 233567 A
- EP 297443 A
- EP 297442 A
- US 4933377 A
- US 161811 A
- US 4760013 A
- US 4734444 A
- US 2833827 A
- DE 2904626
- DE 3604580
- DE 3604581
- JP 2001343742 A
- JP 2002148790 A
- JP 51048516 B
- JP 5047095 B
- JP 2000147763 A
- JP 51047334 B
- JP 57196231 B
- JP 59005240 A
- JP 59005241 A
- JP 2226149 A
- JP 1165613 A
- JP 54021726 B
- JP 48041708 B
- JP 51037193 A

- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 B
- JP 61022048 A
- JP 7021633 B
- JP 62170950 A
- JP 62226143 A
- JP 60168144 A
- JP 62293247 A
- JP 2002287334 A
- JP 2001277740 A
- JP 2001277742 A
- US 2800457 A
- US 2800458 A
- US 3287154 A
- JP 3819574 B
- JP 42446 B
- US 3418250 A
- US 3660304 A
- US 3796669 A
- US 3914511 A
- US 4001140 A
- US 4087376 A
- US 4089802 A
- US 4025445 A
- JP 369163 B
- JP 51009079 B
- GB 930422 A
- US 3111407 A
- GB 952807 A
- GB 967074 A
- JP 54063902 A
- JP 2001253181 A
- JP 2001322365 A
- US 2714066 A
- US 3181461 A
- US 3280734 A
- US 3902734 A
- JP 3622063 B
- US 3276868 A
- US 4153461 A
- US 4689272 A
- JP 2001199175 A
- JP 2002079772 A
- JP 10282679 A
- JP 2304441 A
- JP 5045885 A
- JP 6035174 A
- US 3458311 A
- JP 55049729 B
- JP 49070702 A
- GB 1303578 A

**Non-patent literature cited in the description**

- **Wakabayashi et al.** *Bull. Chem. Soc. Japan,* 1969, vol. 42, 2924
- **M.P.Hutt.** *Journal of Heterocyclic Chemistry,* 1970, vol. 1 (3
- **Kunz, Martin.** *Rad Tech '98. Proceeding,* 19 April 1998
- *J.C.S. Perkin II,* 1979, 1653-1660
- **J.C.S. Perkin II.** *J.C.S. Perkin II,* 1979, 156-162
- *Journal of Photopolymer Science and Technology,* 1995, 202-232
- **S.I. Schlesinger.** *Photogr. Sci. Eng.,* 1974, vol. 18, 387
- **T.S. Bal et al.** *Polymer,* 1980, vol. 21, 423
- **J.V Crivello et al.** *Macromolecules,* 1977, vol. 10 (6), 1307
- **J.V. Crivello et al.** *J. Polymer Sci., Polymer Chem. Ed.,* 1979, vol. 17, 1047
- **C.S. Wen et al.** *Teh, Proc. Conf. Rad. Curing ASIA,* 1988, 478
- *Journal of the Adhesion Society of Japan,* 1984, vol. 20 (7), 300-308